# EUROPÄISCHE PATENTSCHRIFT

(11) **EP 1 496 369 B1**
(45) Veröffentlichungstag und Bekanntmachung des Hinweises auf die Patenterteilung: **09.04.2008**
(21) Anmeldenummer: 04010128.9
(22) Anmeldetag: 28.04.2004
(51) Int. Cl.: G01R 15/14, G01L 1/24

(54) **Optisches Verfahren und optische Einrichtung zur Überwachung eines elektrischen Leiters**
Optical method and apparatus for monitoring an electric conductor
Procédé et appareil optique pour surveiller un conducteur électrique

(30) Priorität: 14.05.2003 DE 10321790; 31.03.2004 DE 102004015875; 05.04.2004 DE 102004016741
(43) Veröffentlichungstag der Anmeldung: 12.01.2005
(73) Patentinhaber: SIEMENS AKTIENGESELLSCHAFT, 80333 München (DE)
(72) Erfinder: Bosselmann, Thomas, Dr., 91080 Marloffstein (DE); Hertsch, Hagen, 91058 Erlangen (DE); Kaiser, Joachim, Dr., 91056 Erlangen (DE); Puschmann, Rainer, 91338 Igensdorf (DE); Theune, Nils-Michael, 91052 Erlangen (DE); Willsch, Michael, 90762 Fürth (DE)

(56) Entgegenhaltungen:
- WO-A-00/68657
- US-A- 5 493 390
- KALINOWSKI H J ET AL: "MULTIPLEXED FIBER OPTICS BRAGG GRATING SENSORS FOR STRAIN AND TEMPERATURE MEASUREMENTS IN POWER SYSTEMS" PROCEEDINGS OF THE SPIE, SPIE, BELLINGHAM, VA, US, Bd. 3666, 1999, Seiten 544-553, XP002931503 ISSN: 0277-786X
- ARAUJO F M ET AL: "SURVEILLANCE OF FIBER OPTIC CABLES AND ELECTRIC POWER CABLES USING FIBER BRAGG GRATING SENSORS" PROCEEDINGS OF THE SPIE, SPIE, BELLINGHAM, VA, US, Bd. 3541, November 1998 (1998-11), Seiten 278-289, XP002931504 ISSN: 0277-786X

## Beschreibung

Die Erfindung betriff eine Oberleitung zur elektrischen Energieversorgung eines Schienentriebfahrzeugs mit optischer Kraftmesseinrichtung sowie ein optisches Kraftmessverfahren zur Bestimmung einer von einem Stromabnehmer des Schienentriebfahrzeugs aus auf die Oberleitung wirkenden Kraft.

Ein Schienentriebfahrzeug wird über einen elektrischen (Strom-)Leiter in Form einer Oberleitung mit elektrischer Energie versorgt. Die Energie gelangt mittels eines mit der Oberleitung in mechanischem Schleifkontakt stehenden Stromabnehmers von der Oberleitung über eine Schleifleiste zum Schienentriebfahrzeug. Um eine hohe Sicherheit, Verfügbarkeit und Zuverlässigkeit zu gewährleisten, sind außer der Oberleitung praktisch alle Betriebsmittel des Bahnenergieübertragung und -verteilung redundant ausgeführt. Bei der Oberleitung erfolgt dies aus technischen und wirtschaftlichen Gründen nicht. Dennoch zieht ein Ausfall der Oberleitung zumindest auf dem vom Oberleitungs-Ausfall betroffenen Streckenabschnitt meistens auch einen Ausfall der kompletten Bahn-Energieversorgung nach sich. Mit jedem derartigen Ausfall sind hohe Kosten verbunden.

Eine Oberleitung besteht im Wesentlichen aus etwa zwanzig, in Reihe geschalteten Teilelementen, die in Form von Maschen angeordnet sind und das so genannte Kettenwerk bilden. Fällt ein Teilelement aus, so fällt auch die Oberleitung insgesamt aus.

Das Ausfallverhalten wird durch zahlreiche Einflussgrößen bestimmt, wobei eine thermische Überlastung einzelner Komponenten der Oberleitung als Hauptursache für die Nichtverfügbarkeit anzusehen ist.

Eine zu hohe thermische Beanspruchung der Oberleitung kann beispielsweise eine unzulässige Längsdehnung des Kettenwerks und damit eine Entgleisung des Stromabnehmers zur Folge haben. Dann ist eine kostenträchtige Beschädigung der Oberleitung und/oder des Stromabnehmers sehr wahrscheinlich. Außerdem kann eine thermische Überlastung zu einer Beeinträchtigung der mechanischen Festigkeit, insbesondere zu einer Entfestigung des Fahrdrahts der Oberleitung führen.

Zu thermischer Überlastung kann es beispielsweise aufgrund einer hohen Außentemperatur, eines hohen Übergangswiderstands an einem sich lockernden Verbindungselement sowie eines zu hohen Stromflusses kommen. Letzteres ist insbesondere angesichts des steigenden Leistungsbedarfs zukünftiger Hochleistungs-Schienentriebfahrzeuge zu beachten. Dieser Bedarf ergibt sich aus dem wachsenden Komfortangebot innerhalb der Fahrzeuge (Vollklimatisierung, TV, Multimedia, usw.), den hohen Stromspitzen durch das Anfahren, den in zunehmendem Maße eingesetzten elektrischen Rückspeisebremsen und der steigenden Zuggeschwindigkeit von 300 km/h und mehr. Daraus resultiert der Wunsch nach einer möglichst hohen Ausnutzung der Oberleitung.

Um dann aber dennoch eine sichere Energieversorgung zu gewährleisten, ist eine genau arbeitende Überlastschutzeinrichtung erforderlich. Sowohl ein unzulässig hoher Betriebsstrom als auch ein Kurzschlussstrom (bis zu 45 kA) werden von einer solchen Schutzeinrichtung erkannt und abgeschaltet. Dadurch wird die Oberleitung vor Abbrand geschützt und die Zahl der Betriebsunterbrechungen reduziert. Diese Schutz-Funktion bietet eine mehrstufige digitale Distanzschutzeinrichtung, wie sie zum Beispiel in *"*Digitalschutz für Bahnenergienetze", H.-J. Braun, et al., Elektrische Bahnen 97, 1999, Heft 1/2, S. 32-39*,* beschrieben ist. Messgrößen sind hierbei in erster Linie die elektrische Spannung und der elektrische Strom.

Um bestehende und neue Bahntrassen für die zukünftigen Anforderungen und gegen zu hohe Ausfallraten zu rüsten, kann zusätzlich ein Monitoring der thermischen Belastung der Oberleitung nützlich sein. Bei einer solchen Einrichtung wird derzeit die primär interessierende thermische Belastung einzelner Komponenten der Oberleitung allerdings nur indirekt anhand verschiedener Hilfs-Messgrößen ermittelt. Wie aus dem Gerätehandbuch "Siemens Digitaler Oberleitungsschutz 7SA517 V3.4", Siemens AG, Transportation Systems, 08/2001, Bestell Nr. E50410-A0011-U501-A2-0091, Seiten 3-12 bis 3-14 hervorgeht, basiert dieser thermische Überlastschutz auf einem thermischen Modell mit Gedächtnisfunktion, das unter Zugrundelegung des Stromeffektivwertes und der Außentemperatur die Temperatur des Fahrdraht der Oberleitung berechnet und diese mit einem einstellbaren zulässigen Maximalwert vergleicht. Die Verwendung des thermischen Modells kann jedoch zu einem ungenauen Resultat führen. Die rechnerisch ermittelte und die tatsächlich vorliegende Temperatur der Oberleitungskomponente können voneinander abweichen mit der Folge, dass eine abgeleitete Schutzmaßnahme nicht optimal auf die tatsächlichen Gegebenheiten abgestimmt ist.

Ein ähnliches Verfahren zur Zustandsüberwachung einer Hochspannungs-Freileitung, bei dem ein Approximationsmodell zur indirekten Ermittlung der Leitertemperatur zum Einsatz kommt, wird mit der DE 19718186 C1 offenbart.

In den Schutzrechten US 4635055 A1*,* US 4894785 A1*,* US 4904996 A1*,* US 5006846 A1 und US 5341088 A1 werden jeweils elektrische Sensoren beschrieben, die zur Montage an einer Hochspannungs-Freileitung bestimmt sind und die aus dem zu überwachenden Leiter mit elektrischer Energie gespeist werden. Erfasst werden auf Hochspannungspotential vielfältige Messgrößen wie Sonneneinstrahlung, Leiterstrom, Leiterspannung, Windgeschwindigkeit und -richtung, relative Feuchte, Außentemperatur, und auch die Temperatur und Dehnung des Hochspannungs-Leiters. Die erfassten Signale werden per Funkverbindung oder bei der in der US 5006846 A1 gezeigten Einrichtung per optischer Verbindung an eine Bodenstation übertragen. Diese Sensoren haben alle eine den zu überwachenden Leiter komplett umschließende Konstruktion, die zur induktiven Auskopplung der zum Betrieb der elektrischen Sensoren benötigten Energie aus dem zu überwachenden Leiter insbesondere auch einen magnetischen Transformator, beispielsweise in Form eines magnetischen Ringkern-Wandlers, beinhaltet. Ein Einsatz in der Bahn-Energieversorgung ist somit wegen des dort üblichen Schleifkontakts zwischen dem Stromabnehmer und dem Fahrdraht technisch nur schwer oder gar nicht möglich.

Mit dem Aufsatz *"*Measurements of overhead transmission line loads with Bragg gratings", L.Bjerkam, Conference Proceedings, SPIE Vol. 3746, S.514-517, OFS-13, Kyongju, Korea, 12.-16.04.1999*,* wird eine Dehnungsmessung an einer Hochspannungsfreileitung mittels Faser-Bragg-Gitter-Sensoren (FBG)-Sensoren offenbart. Zur Messung von dynamischen Dehnungsamplituden des stromführenden Leiters sind an einem 160 m langen Teilstück einer 60 kV-Freileitung insgesamt drei Fig-Sensoren angeordnet. Einer davon dient zur Erfassung einer Temperaturreferenz. Die beiden FBG-Sensoren zur Dehnungsmessung sind direkt auf den zu überwachenden Leiter geklebt. Von einem eingespeisten Lichtsignal wird ein Anteil mit der Schwerpunktswellenlänge des jeweiligen FBG-Sensors zu einer Auswerteeinheit zurückreflektiert. Die Schwerpunktswellenlänge ändert sich mit der am Messort herrschenden Dehnung, so dass ihre Veränderung als Messgröße für die Dehnung verwendet werden kann.

Die faseroptische Überwachung von Überlandleitungen ist ebenfalls Gegenstand des Artikels *"*Multiplexed fiber optics bragg grating sensors for strain and temperature measurements in power systems", H.J.Kalinowski et al., Conference Proceedings, SPIE Vol. 3666, S. 544-553, Bellingham, VA, US, 1999 und der WO 00/68657 A. So ist es möglich, mittels mehrerer an unterschiedlichen Stellen entlang von Überlandleitungen angebrachter Faser-Bragg-Gitter-Sensoren Temperaturen und Dehnungen der Überlandleitungen ortsaufgelöst zu bestimmen.

Die allgemeine Eignung und Verwendung von Faser-Bragg-Gitter-Sensoren zur Überwachung von Dehnungen und Temperaturen sicherheitskritischer Strukturen und Komponenten insbesondere im Bereich der Luft- und Raumfahrt ist in der US 5,493,390 beschrieben. Die Sensoren sind dabei auf den zu überwachenden Strukturen angebracht oder in diesen eingebettet.

Ein signifikanter Anteil der Ausfallursachen von Oberleitungen kann auch auf eine fehlerhafte Interaktion zwischen Schienentriebfahrzeug und der Oberleitung zurückgeführt werden.

So kann die Presskraft des Stromabnehmers an den so genannten Fahrdraht der Oberleitung unangemessen sein. Bei überhöhten Anpresskräften, die auch Kontaktkräfte genannt werden, wird der Fahrdraht und auch die Schleifleiste einem übermäßigen Verschleiß ausgesetzt. Bei zu niedrigen Kontaktkräften kann es im Fahrbetrieb auch zu Kontaktverlusten kommen, die Lichtbögen zwischen Fahrdraht und Schleifleiste hervorrufen können. Durch die sehr hohen Temperaturen im Lichtbogen können Schäden durch Materialabtrag am Fahrdraht und am Stromabnehmer entstehen. Weist die Schleifleiste beispielsweise Riefen auf, kann im Fahrbetrieb der Fahrdraht kurzzeitig in diese Riefen mitgeführt werden. Dies kann zu unspezifischen Auslenkungen des gesamten Kettenwerks führen. Im schlimmsten Fall kann es dabei zu einer "Entgleisung" des Stromabnehmers kommen.

Für Infrastrukturbetreiber, die für die Oberleitung verantwortlich sind, ist es daher von großem Interesse, mit einem so genannten "Quality Gate" die Interaktion zwischen der Oberleitung und dem entsprechenden Schienentriebfahrzeug erfassen zu können, um gegebenenfalls regulierend einzugreifen und auch beispielsweise die Schuldfrage bei Vorfällen eindeutig klären zu können. In *"*Stromabnehmerdiagnose im laufenden Betrieb durch stationäre Anhubmessung", H. Möller, et al. Elektrische Bahnen 100, 2002, Heft 6, S. 198-203 ist ein solches "Quality Gate" beschrieben. Die Veröffentlichung legt dar, wie mit der Ermittlung des Fahrdrahtanhubs auf die Kontaktkraft zwischen Stromabnehmer und Fahrdraht geschlossen wird, um defekte oder falsch eingestellte Stromabnehmer zu erkennen. Dabei wird der Anhub mit einem Seilzugpotentiometer als mechanischem Wegsensor gemessen. Das elektrische Signal des Seilzugpotentiometers wird dann zur Weiterverarbeitung über ein Kabel und einen Trennverstärker einem Messverstärker zugeführt.

Der Erfindung liegt nun die Aufgabe zugrunde, ein Verfahren und eine Einrichtung anzugeben, die verglichen mit dem Stand der Technik eine verbesserte Überwachung einer Oberleitung zur elektrischen Energieversorgung eines Schienentriebfahrzeugs im Hinblick auf thermische und/oder mechanische Belastungen ermöglicht.

Die die Einrichtung betreffenden Aufgabe wird erfindungsgemäß mit den in Anspruch 1 angegebenen Maßnahmen gelöst.

Demgemäß handelt es sich um eine Oberleitung zur elektrischen Energieversorgung eines Schienentriebfahrzeugs mit optischer Kraftmesseinrichtung umfassend
- mindestens einen in oder an einer Komponente der Oberleitung kraftschlüssig angeordneten Faser-Bragg-Gitter-Sensor,
- Einspeisemittel zur Einspeisung eines Lichtsignals in den mindestens einen Faser-Bragg-Gitter-Sensor, wobei
- eine Verformung der Komponente durch eine von außen von einem Stromabnehmer des Schienentriebfahrzeuges auf die Oberleitung wirkende Kraft bewirkt ist, und
- die zu ermittelnde Verformung der Komponente der Oberleitung mit einer Änderung des Lichtsignals behaftet ist, und
- Auswertemittel, mit welchen ein Messwert für die auf die Oberleitung vom Stromabnehmer aus wirkende Kraft aus der verformungsbedingten Änderung des Lichtsignals zu bestimmen ist.

Die das Verfahren betreffende Aufgabe wird erfindungsgemäß mit den in Anspruch 21 angegebenen Maßnahmen gelöst.

Demgemäß handelt es sich um ein optisches Kraftmessverfahren zur Bestimmung einer von einem Stromabnehmer eines Schienentriebfahrzeugs aus auf eine zur elektrischen Energieversorgung des Schienentriebfahrzeugs bestimmten Oberleitung wirkenden Kraft, bei welchem Verfahren
- mindestens ein Faser-Bragg-Gitter-Sensor kraftschlüssig in oder an einer Komponente der Oberleitung angeordnet wird,
- ein in den mindestens einen Faser-Bragg-Gitter-Sensor eingespeistes Lichtsignal aufgrund einer Verformung der Kompotente der Oberleitung verändert wird, wobei die Verformung der Komponente durch die von außen vom Stromabnehmer auf die Oberleitung wirkende Kraft bewirkt wird,
   und
- aus der verformungsbedingten Veränderung des Lichtsignals ein Messwert für die auf die Oberleitung vom Stromabnehmer aus wirkende Kraft ermittelt wird.

Die Erfindung beruht dabei auf der Erkenntnis, dass durch die Verwendung eines optischen Sensors zur Erfassung einer physikalischen Größe, mit der beispielweise eine thermische und/oder mechanische Belastung der Leiterkomponente einher geht, die tatsächliche physikalische Größe wesentlich genauer bestimmt werden kann, als bei den derzeit aus dem Stand der Technik bekannten Überwachungs- bzw. Schutzeinrichtung für Oberleitungen.

Als zu überwachende Komponenten des Leiters, der insbesondere auch als Leitersystem, wie bei einer Bahn-Oberleitung, ausgebildet sein kann, kommen beispielsweise ein metallischer Draht oder verseilter Drahtstrang, ein Verbindungselement wie eine Klemme oder auch ein massives Gussbauteil in Betracht. Aufgrund seiner geringen Baugröße lässt sich ein optischer Sensor leicht an oder in einer solchen Komponente anbringen. Hierfür ist entweder gar keine oder nur eine sehr geringfügige konstruktive Anpassung der Komponente, beispielsweise in Form einer Nut, eines Bohrlochs oder eines Adapterstücks, erforderlich.

Ein Vorteil eines optischen Sensors gegenüber einem konventionellen elektrischen Sensor ist seine intrinsische Potentialtrennung. Die optische Abfrage kann mittels einer optischen Freistrahlanordnung oder auch mittels mindestens einer dielektrischen Zuleitung, beispielsweise in Gestalt eines Lichtwellenleiters aus Glas oder aus Kunststoff, erfolgen. Damit ist es möglich, ohne gesondertem oder mit verhältnismä-ßig geringem Isolationsaufwand eine solche dielektrische Zu- oder Ableitung zu installieren. Aufgrund der hohen Verfügbarkeit von Standard-Glasfaserkomponenten, die sich besonders gut für die dielektrische Zu-/Ableitung einsetzen lassen, resultiert neben einem technischen auch ein großer wirtschaftlicher Vorteil.

Der optische Sensor ist als Faser-Bragg-Gitter(FBG)-Sensor ausgebildet. Dieser Sensor-Typ zeichnet sich durch seine besondere Multiplexfähigkeit aus, so dass auf einfache Weise ein Sensor-Netzwerk realisiert werden kann, wobei die einzelnen FBG-Sensoren auch auf unterschiedliche Einflussgrößen wie beispielsweise auf die Temperatur oder die Dehnung des Leiters empfindlich sein können. Ein weiterer Vorteil der FBG-Technologie ist die Möglichkeit einer praktisch punktförmigen, also einer lokal sehr eng begrenzten Messung. Demgegenüber hat ein grundsätzlich ebenfalls denkbarer optischer Sensor nach dem Brilloin- oder Raman-Prinzip üblicherweise eine gewisse lokal integrierende Wirkung, die zum Beispiel über mehrere Meter reicht. Eine punktförmige Messung, d.h. insbesondere eine lokale Beschränkung der Erfassungsstelle auf wenige Millimeter, wäre mit diesen Typen von optischen Sensoren dann also nur sehr schwer zu erreichen. Mit einem FBG-Sensor ist dies jedoch ohne weiteres möglich.

Die einzelnen FBG-Sensoren können beispielsweise mit vorbestimmten Abständen zwischen 1 cm und mehreren km in Serie in einen einzigen Lichtwellenleiter eingeschrieben sein. Ein Aufbau mit mehreren parallelen Lichtwellenleitern, in denen jeweils mehrere FBG-Sensoren angeordnet sind, ist ebenfalls möglich. Damit ist es möglich 100 und mehr Sensoren in einem Lichtwellenleiter-Strang unterzubringen und auszulesen. Zur besseren Unterscheidbarkeit haben zumindest die in einem Lichtwellenleiter angeordneten FBG-Sensoren vorzugsweise jeweils eine voneinander verschiedene Schwerpunktwellenlänge. Dies ist jedoch keine absolute Bedingung, denn auch bei gleicher Schwerpunktwellenlänge lassen sich Antwortsignale verschiedener FBG-Sensoren beispielsweise mittels eines OTDR's (Optical Time Domain Reflectometer) voneinander unterscheiden.

In jedem FBG-Sensor wird vom eingespeisten Lichtsignal ein durch die jeweilige Schwerpunktwellenlänge bestimmter Anteil zurückreflektiert. Die Schwerpunktwellenlänge ändert sich mit der am Messort herrschenden Einflussgröße, hier insbesondere der Temperatur und/oder der Dehnung. Diese Veränderung im Wellenlängengehalt (oder Wellenlängenspektrum) des jeweiligen zurückreflektierten (Teil-)Lichtsignals kann als Maß für die zu erfassende Einflussgröße verwendet werden. Zur Abfrage mittels des Lichtsignals kommt insbesondere eine breitbandige Lichtquelle, wie beispielsweise eine LED mit einer Bandbreite von etwa 45 nm, eine SLD mit einer Bandbreite von etwa 20 nm oder ein durchstimmbarer Laser mit einer Bandbreite von etwa 100 nm zum Einsatz. Der Einsatz eines anderen optischen Sensors zur unmittelbaren Temperaturerfassung ist grundsätzlich ebenfalls möglich. So ist beispielsweise ein optischer Sensor einsetzbar, der eine temperaturbedingte Intensitätsänderung im eingespeisten Lichtsignal hervorruft oder der auf Thermolumineszenz beruht. Auch für die Dehnungsmessung lässt sich prinzipiell ein anderer optischer Sensor einsetzen, beispielsweise auf Basis eines faseroptischen Fabry-Perot-Interferometers.

Das Verfahren und die Einrichtung wird erfindungsgemäß zur Überwachung der in der elektrischen Energieversorgung des Schienentriebsfahrzeugs (= Bahn-Energieversorgung) vorhandenen Oberleitung eingesetzt. Eine Oberleitung beinhaltet hierbei Tragmasten, an denen in einigen Metern Höhe über den Bahngleisen ein Kettenwerk befestigt ist. Das Kettenwerk umfasst im Wesentlichen ein an den Masten befestigtes Tragseil, an dem unter Zwischenschaltung von Hängern der Fahrdraht befestigt ist. Insbesondere zur Überwachung dieses Kettenwerks, das bislang nur schwer oder überhaupt nicht auf eine tatsächliche thermische oder mechanische Beanspruchung zu überwachen war, lassen sich die genannten optischen Sensoren mit Vorteil einsetzen.

Vorteilhafte Ausgestaltungen der Einrichtung und des Verfahrens gemäß der Erfindung ergeben sich aus den von Anspruch 1 bzw. 21 abhängigen Ansprüchen.

Besonders vorteilhaft ist, die Temperatur der Komponente des Leiters zu bestimmen. Die direkte Temperaturerfassung erübrigt das in einer gängigen digitalen Oberleitungsschutzeinrichtung zugrunde gelegte numerische Modell zur Approximation der Leitertemperatur. Damit treten auch die durch das Approximationsmodell bedingten Unsicherheiten und/oder Ungenauigkeiten nicht mehr auf.

Fehlerursachen sind beim Approximationsmodell beispielsweise die Nichtberücksichtigung von Wetterfaktoren wie Windgeschwindigkeit, Windtemperatur, Sonneneinstrahlung, Schattenwurf, relative Luftfeuchte, Niederschlag (Regen, Schnee) und auch die Nichtberücksichtigung topographischer Besonderheiten wie die Höhendifferenz zwischen dem Ort, an dem der elektrische Außentemperatur-Messfühler angebracht ist und dem Ort, an dem die Leitertemperatur eigentlich ermittelt werden soll. Diese Fehlerursachen spielen bei einer direkten Temperaturmessung mittels eines optischen Sensors keine Rolle mehr.

Wenn der Leiter, wie beispielsweise bei einer Bahn-Oberleitung, als Leitersystem mit mehreren parallelen und/oder verzweigten Teilstrompfaden ausgebildet ist, berücksichtigt das Approximationsmodell die Gesamtstrommenge, nicht jedoch die Teilströme in den einzelnen Teilstrompfaden, so dass eine zunächst nur lokale thermische Überlastung in einem dieser Teilstrompfade auch unerkannt bleiben kann. Durch gezieltes Anbringen eines optischen Temperatur-Sensors an einer als diesbezüglich kritisch bekannten Messstelle, beispielsweise an einer stromführenden Klemmstelle mit erhöhten ohmschen Widerstandsverlusten (Erwärmung), lässt sich auch diese Fehlerquelle des Approximationsmodells wirksam beseitigen.

Durch die Einbindung der tatsächlich ermittelten Temperatur in ein entsprechendes Schutzkonzept kann also ein verbesserter Schutz vor thermischer Überlastung des Leiters erzielt werden. Anhand der direkt gemessenen Temperatur-Information kann eine zustandsorientierte Reduzierung des im Leiter fließenden Stroms, oder auch eine zustandsorientierte Wartung erfolgen.

Die aufgrund des unsichereren Approximationsmodells bislang vorgesehenen Sicherheitsreserven im Schutzkonzept können bei Ermittlung der tatsächlichen thermischen Belastung außerdem zumindest deutlich reduziert werden, wodurch der Leiter bei einem höheren Strom betrieben werden kann. Gleichzeitig wird eine Schutzmaßnahme, beispielsweise eine Reduzierung des Stromflusses oder eine komplette Freischaltung, nur bei einer tatsächlich vorhandenen thermischen Überlastung, also insbesondere bei Überschreiten eines thermischen Grenzwerts, vorgenommen. Es ist auch ein mehrstufiges oder gestaffeltes Schutzkonzept mit mehreren solcher Grenzwerte möglich, bei dem die eingeleiteten Schutzmaßnahmen dann je nach überschrittenem Grenzwert unterschiedlich ausfallen. Insgesamt wird die Gefahr einer kostenträchtigen irrtümlichen Freischaltung des Leiters aufgrund der Einbeziehung der tatsächlichen thermischen Belastung also erheblich reduziert.

Weiterhin kann die betreffende Leiterkomponente bei genauer Kenntnis ihrer Temperatur in einer anderen Ausführungsform, insbesondere mit kleinerem Querschnitt, realisiert werden. Dadurch ergibt sich eine Materialeinsparung und folglich auch ein Kostenvorteil.

Außerdem lässt sich anhand des optischen Sensors auch die Temperatur einer nicht stromführenden Komponente des Leiters erfassen. Dies ist bei dem Approximationsmodell, das im Wesentlichen auf einer Auswertung gemessener aktueller und vergangener Stromwerte basiert, nicht möglich. Eine thermische Überlastung, die die Veranlassung einer geeigneten Schutzmaßnahme erforderlich macht, kann aber auch in einer nicht stromführenden Komponente des Leiters auftreten. Auch diesbezüglich wird somit ein verbesserter Schutz erreicht.

Günstig ist es insbesondere, wenn Steuermittel zur Veranlassung einer Schutzmaßnahme für den Leiter in Abhängigkeit des Temperaturmesswerts vorgesehen sind. Damit kann beispielsweise durch eine automatische Regelung unmittelbar bei Auftreten von die Oberleitung gefährdenden Unregelmäßigkeiten entgegengewirkt werden.

Weiter ist es dabei von Vorteil, dass weitere optische Sensoren zur Temperaturerfassung vorgesehen sind. Diese Sensoren können dann über eine bestimmte Strecke längs des zu überwachenden Leiters an oder in verschiedenen Komponenten des Leiters angeordnet sein. Damit lässt sich ein besserer Gesamteindruck von der tatsächlichen thermischen Belastung des Leiters gewinnen. Außerdem ist es ebenfalls möglich, dass die optischen Sensoren an verschiedenen Teilleitern des Leiters angebracht sind. Dies ist dann von Vorteil, wenn der Leiter als Leitersystem ausgebildet ist, das sich unter anderem auch aus den genannten mehreren Teilleitern zusammensetzt.

Vorzugsweise wird zumindest längs eines gewissen Teilabschnitts des Leiters ein Profil für die lokale Temperaturverteilung erstellt. Dies kann insbesondere durch Zugrundelegung von Temperaturmesswerten von verschiedenen Messstellen erfolgen. Die so bestimmte lokale Temperaturverteilung vermittelt einen sehr guten Eindruck der tatsächlichen thermischen Belastung - zumindest längs des betreffenden Teilabschnitts des Leiters.

Außer der Temperatur können auch andere Messgrößen optisch erfasst werden. Insbesondere von Interesse ist hierbei die mechanische Dehnung des Leiters oder einer Leiterkomponente. Hierzu wird, analog zur Temperaturerfassung, ein optischer Dehnungssensor an oder in der Komponente des Leiters angeordnet. Eine gute kraftschlüssige Verbindung zum Messobjekt wirkt sich dabei positiv auf die Qualität der Dehnungsmessung aus. Dies kann beispielsweise durch eine insbesondere wetterfeste Klebstoffverbindung, eine mechanische Klemmverbindung, eine Schraubverbindung oder eine Lötverbindung bewerkstelligt werden. Auch die Dehnung kann an verschiedenen Messorten, die insbesondere längs eines Teilabschnitts des zu überwachenden Leiters angeordnet sind, erfasst werden. Ebenso ist es möglich, eine Dehnungsverteilung zumindest längs eines Teilabschnitts des zu überwachenden Leiters zu bestimmen. Eine übermäßige mechanische Dehnung des Leiters oder auch nur einer Komponente des Leiters ist ein Indiz für eine - dann mechanische - Überlastung. Zum Schutz vor derartiger Überbeanspruchung können auch die optisch erfassten Dehnungsmesswerte und/oder die Dehnungsverteilung in ein entsprechendes Schutzkonzept eingebunden werden.

Sowohl die Temperaturmesswerte von verschiedenen Messstellen am Leiter als auch eine gegebenenfalls ermittelte Temperaturverteilung lassen sich mit Vorteil in das Schutzkonzept für den Leiter einbinden. Anhand dieser zusätzlichen Informationen kann ein besonders wirksamer Schutz des Leiters vor thermischer Überbeanspruchung erreicht werden.

Weitere vorteilhafte Ausgestaltungen der Einrichtung, insbesondere zur Temperaturüberwachung, beziehen sich auf verschiedene Anbringungs- oder Befestigungsmöglichkeiten des optischen Sensors an der zu überwachenden Leiterkomponente.

Zum Schutz vor einer zu hohen mechanischen und/oder klimatischen Beanspruchung kann der optische Sensor in einem gesonderten Gehäuse untergebracht sein.

Der optische Sensor lässt sich aufgrund seiner geringen Baugröße bevorzugt in einem Hohlraum innerhalb der zu überwachenden Leiterkomponente unterbringen. Dieser Hohlraum kann gezielt zur Befestigung des optischen Sensors in die Leiterkomponente eingebracht werden, es kann sich jedoch auch um einen in der Leiterkomponente bereits ohnehin vorhandenen Hohlraum handeln. Bei Bedarf kann der optische Sensor zusammen mit einem Gehäuse in einem derartigen Hohlraum untergebracht werden.

Weiterhin kann ein an der Leiterkomponente angebrachtes Aufnahmeelement vorgesehen sein, in dem der optische Sensor platziert werden kann.

Unabhängig davon, ob der optische Sensor als solcher, mittels eines Gehäuses oder mittels eines Aufnahmeelements an oder in der Leiterkomponente angeordnet ist, lassen sich zur Verbindung des optischen Sensors mit der Leiterkomponente eine Kleb-, Löt-, Klemm- oder Schraubverbindung sinnvoll einsetzen. Je nach Bedarf kann insbesondere so auch problemlos ein guter thermischer Kontakt zur Messstelle hergestellt werden.

Insbesondere kann so auch problemlos ein guter kraftschlüssiger Kontakt zur Messstelle hergestellt werden.

Es ist besonders vorteilhaft, wenn an dem Leiterabschnitt mindestens ein zweiter optischer Sensor angeordnet wird, mit dem mindestens ein zweiter Messwert in entsprechender Weise ermittelt wird und wobei mindestens eine von außen auf den Leiter wirkende Kraft den mindestens zwei Messwerten der mechanischen Belastung zugeordnet wird. Denn bei einer Krafteinwirkung, beispielsweise senkrecht auf die Längsachse eines verformbaren Leiters, wird dieser gekrümmt. Durch die Krümmung wird die Oberfläche des Leiters an einer Seite eines Längenabschnittes gedehnt, während sie auf der anderen, insbesondere gegenüberliegenden Seite desselben Längenabschnittes weniger stark gedehnt oder gar gestaucht wird. Durch Anbringen mindestens zweier optischer Sensoren zur Ermittlung der Verformung des Leiters an diese beiden Oberflächenbereiche kann durch Vergleich der dabei erlangten Messwerte bestimmt werden, wie stark und in welcher Richtung der Leiter durch die Krümmung verformt wird. Daraus lässt sich dann auf die Richtung und Stärke der auf den Leiter wirkenden Kraft schließen. Somit wird mit der Erfindung eine detailliertere Ermittlung der auf die Oberleitung wirkende mechanische Belastung ermöglicht, die darüber hinaus bei einer Anwendung über längere Streckenabschnitte kostengünstiger anzuwenden ist.

Günstig ist es insbesondere, wenn weitere optische Sensoren entlang des Leiters zur Ermittlung einer auf den Leiter wirkenden mechanischen Belastung vorgesehen sind. Diese Sensoren, insbesondere Sensorenpaare, können dann über eine bestimmte Strecke längs des zu überwachenden Leiters an verschiedenen Komponenten des Leiters angeordnet sein. Damit lässt sich ein besserer Gesamteindruck von der tatsächlichen mechanischen Belastung des Leiters gewinnen. Darüber hinaus ist es auch denkbar, bei einer gleichzeitigen Zeitnahme die Dynamik des Leitersystems bei Krafteinwirkung zu untersuchen.

Die optischen Sensoren sind erfindungsgemäß als Faser-Bragg-Gitter(FBG)-Sensoren ausgebildet. Neben der bereits vorangehend beschriebenen Vorteile dieses Sensorentyps kommt hinzu, dass es möglich ist, bei Notwendigkeit einer höheren Messgenauigkeit mehrere Sensoren nahe beieinander an der Leiteroberfläche zu platzieren. Zudem haben auch diejenigen Sensoren, insbesondere Sensorenpaare, die zur Verformungsmessung eines bestimmten Leiterabschnitts verwendet werden, vorzugsweise unterschiedliche Schwerpunktswellenlängen.

Ferner ist neben der vorangehend beschriebenen Messung im Reflektionsmodus auch eine Messung im Transmissionsmodus möglich. Dabei ist das transmittierte (Teil-)Lichtsignal auf die Veränderung im Wellenlängenspektrum zu untersuchen.

Der Einsatz eines anderen optischen Sensors zur unmittelbaren Erfassung der Leiterverformung ist grundsätzlich ebenfalls möglich. So ist beispielsweise ein optischer Sensor auf Basis eines faseroptischen Fabry-Perot-Interferometers denkbar.

Es ist insbesondere vorteilhaft, dass zur Überwachung der mechanischen Belastung die optischen Sensoren kraftschlüssig an der Komponente des Leiters angeordnet sind. Dies gewährleistet, dass die kraftbedingte Verformung des Leiters vollständig auf die Sensoren übertragen wird.

Dabei ist es besonders vorteilhaft, dass die optischen Sensoren in mindestens einer Nut an der Komponente des Leiters angeordnet sind. Damit vergrößert sich der Kontaktbereich zwischen den Sensoren und dem zu untersuchenden Leiter. Dies gewährt eine verbesserte Kontaktierung.

Dabei lassen sich zur Verbindung des optischen Sensors mit der Leiterkomponente eine Klebe- oder Lötverbindung sinnvoll einsetzen. Diese Verbindungsarten sind leicht auszuführen, gewähren eine kraftschlüssige Verbindung und sind zudem kostengünstig in ihrer Anwendung.

Insbesondere bei einem Einsatz zur Überwachung der thermischen und/oder mechanischen Belastung einer Bahn-Oberleitung ist es bevorzugt, mindestens einen optischen Sensor an einer Seite des zu überwachenden Leiters, vorzugsweise des Fahrdrahtes, anzubringen, die derjenigen Seite gegenüber liegt, an der der Stromabnehmer des Schienentriebfahrzeuges mit dem Leiter in Schleifkontakt tritt. Dadurch wird eine Beschädigung des mindestens einen optischen Sensors durch die Schleifleiste des Schienentriebfahrzeuges verhindert.

Weiter ist es vorteilhaft, dass Mittel zur Identifikation des Schienenfahrzeugs vorgesehen sind und dem Schienenfahrzeug, welches die Kraft auf die Leiterkomponente ausübt, die Messwerte zuzuordnen sind. Zudem kann es von Vorteil sein, dass diese Daten erfasst und gespeichert werden können. Beispielsweise ermöglicht dies, bei verursachten Schäden den Verursacher auch zu einem späteren Zeitpunkt eindeutig zu identifizieren. Als Identifikationsmittel ist es denkbar, eine Sende/Empfangseinheit zu verwenden, die bei der Einfahrt des Schienentriebfahrzeuges in das "Quality Gate" beispielsweise von einem am Schienentriebfahrzeug angebrachten elektromagnetischen Sender die zur Identifizierung des Fahrzeuges notwendigen Daten empfängt.

Weiter ist es dabei von Vorteil, dass Steuermittel zur Veranlassung einer Schutzmaßnahme für den Leiter in Abhängigkeit der von außen auf den Leiter wirkenden Kraft vorgesehen sind. Hierbei könnten beispielsweise per Funkübertragung Regelsignale an das Schienentriebfahrzeug gesendet werden.

Weitere vorteilhafte Ausgestaltungen der Einrichtung, insbesondere zur Überwachung der Temperatur und/oder zur Überwachung der mechanischen Belastung, beziehen sich auf verschiedene Anbringungs- oder Befestigungsmöglichkeiten, insbesondere in Form von Klemmenverbindungen.

Besonders vorteilhaft ist, wenn Mittel zur Fixierung der Klemmverbindung an dem Fahrdraht unter Ausbildung einer Vorspannung vorgesehen sind. Somit können in einfachster und zuverlässigster Weise Lichtwellenleiter zum Messort geführt werden und optische Sensoren am Messort den Messbedingungen entsprechend fixiert werden.

Dabei ist es besonders von Vorteil, wenn mit Hilfe der Vorspannung in der Klemmverbindung mindestens ein optischer Sensor an der Klemmverbindung fixiert ist. Damit ist nur ein Vorspannmittel zum gleichzeitigen Fixieren von optischem Sensor und Klemmverbindung am Fahrdraht notwendig.

Vorzugsweise ist mit Hilfe der Vorspannung die Klemmverbindung formschlüssig und/oder kraftschlüssig und/oder wärmeschlüssig an den Fahrdraht angeordnet. Dies ermöglicht eine möglichst zuverlässige Temperatur- und/oder Verformungsübertragung von der zu untersuchenden Leiterkomponente auf den optischen Sensor.

Bevorzugt günstig ist es, das die Klemmverbindung an einem oder an jeweils einem Ende ein Aufnahmeelement umfasst und mit einer klammerartigen Umfassung mit einem elastischen Bügel ausgestaltet ist, wobei mit Hilfe des elastischen Bügels das eine bzw. die beiden Aufnahmeelemente formschlüssig und/oder kraftschlüssig und/oder wärmeschlüssig unter Ausbildung der Vorspannung jeweils in einer Aussparung des Fahrdrahtes angeordnet sind. Dabei kann auf ein zusätzliches Vorspannungsmittel verzichtet werden. Damit erreicht man eine schnellere und vereinfachtere Anbringung der Klemmvorrichtung an die entsprechende Leiterkomponente.

Die vorstehend genannten Möglichkeiten zur Anbringung des mindestens einen optischen Sensors an der zu überwachenden Leiterkomponente sind auch für sich genommen, also insbesondere auch ohne Einbindung in ein nachgeschaltetes Überwachungs- und/oder Schutzkonzept, vorteilhaft.

Bevorzugte, jedoch keinesfalls einschränkende Ausführungsbeispiele der Erfindung werden nunmehr anhand der Zeichnung näher erläutert. Zur Verdeutlichung ist die Zeichnung nicht maßstäblich ausgeführt, und gewisse Aspekte sind schematisiert dargestellt. Im Einzelnen zeigt die
- Figur 1: eine Einrichtung zur Überwachung insbesondere der thermischen Belastung eines Leiters ,
- Figur 2: ein in einem Gehäuse angeordneter Faser-Bragg-Gitter-Sensor,
- Figur 3: Anbringung eines eingebetteten Sensors gemäß Figur 2 an Verbindungselementen des Leiters,
- Figur 4 bis Figur 7: Anbringung eines Lichtwellenleiters inklusive eines Faser-Bragg-Gitter-Sensors an oder in einem Fahrdraht,
- Figur 8: eine Einrichtung zur Überwachung insbesondere der mechanischen Belastung eines Leiters,
- Figur 9: einen Fahrdrahtabschnitt mit einem FBG-Sensorpaar, eingeschrieben in einem Lichtwellenleiter,
- Figur 10: einen Fahrdrahtabschnitt mit einem FBG-Sensorpaar, eingeschrieben in zwei Lichtwellenleitern,
- Figur 11 bis Figur 13: Anbringungsbeispiele für mindestens eines Lichtwellenleiters inklusive Faser-Bragg-Gitter-Sensoren an einem Fahrdraht, dargestellt im Fahrdrahtquerschnitt,
- Figur 14: einen Fahrdrahtabschnitt mit einem an den Fahrdraht angebrachten Lichtwellenleiter mit einem "Single-Ended"-Faser-Bragg-Gitter-Sensor,
- Figur 15: ein Anbringungsbeispiel für einen Lichtwellenleiter an einem Fahrdraht,
- Figur 16 bis Figur 17: Anbringungsbeispiele für mindestens einen Lichtwellenleiter inklusive Faser-Bragg-Gitter-Sensoren an einem Fahrdraht mit zusätzlichem Vorspannmittel und
- Figur 18 bis Figur 19: ein Anbringungsbeispiel für mindestens einen Lichtwellenleiter inklusive Faser-Bragg-Gitter-Sensoren an einem Fahrdraht ohne zusätzlichem Vorspannmittel.

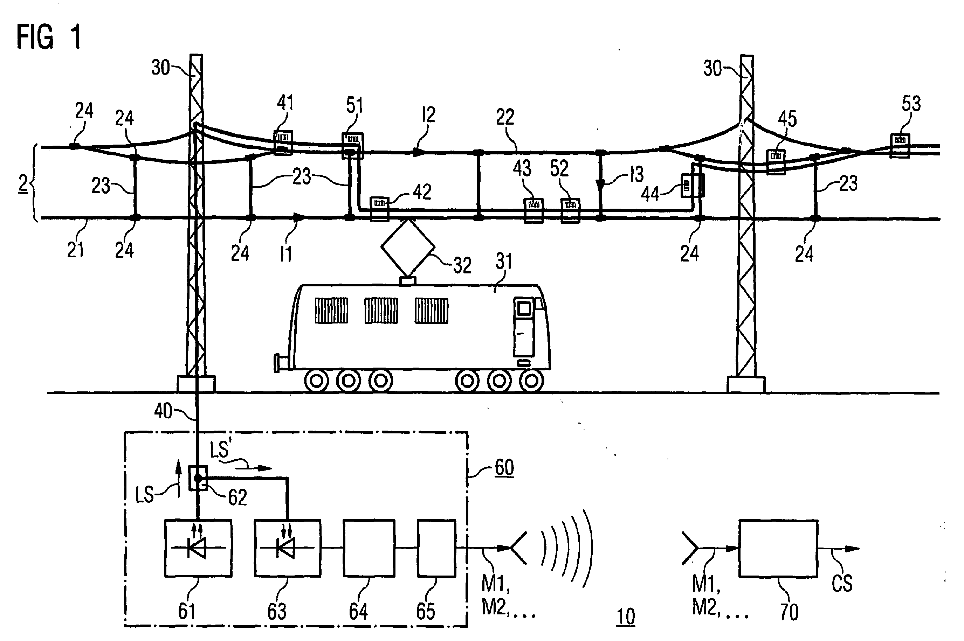

Einander entsprechende Teile sind in den Figuren 1 bis 19 mit denselben Bezugszeichen versehen.

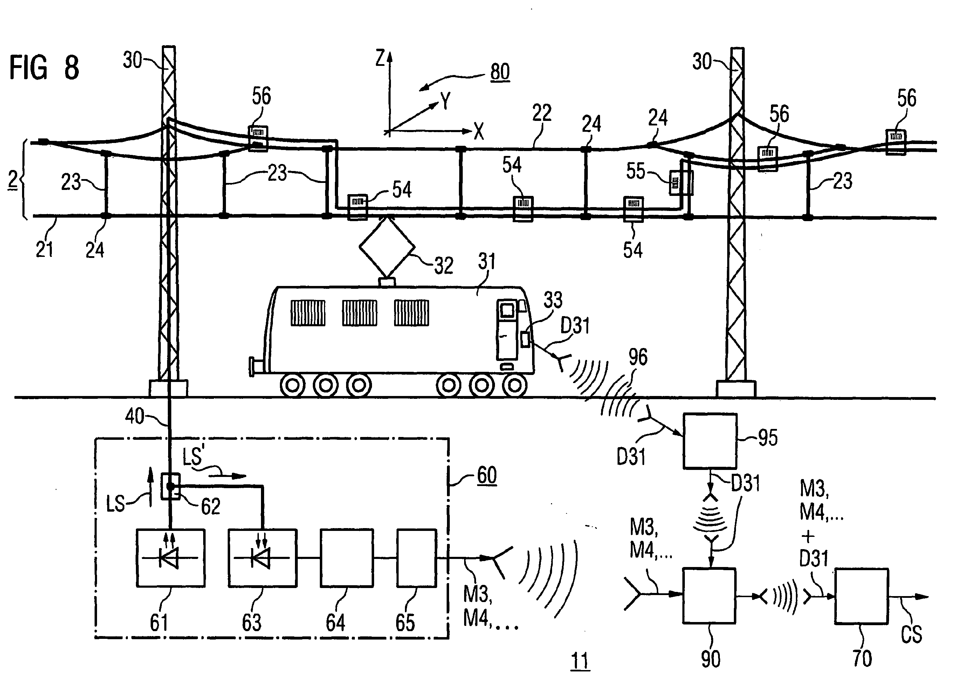

In Figur 1 ist eine Überwachungseinrichtungen 10 zur Überwachung insbesondere der thermischen Belastung eines Leiters 2 in Form eines Kettenwerks einer Bahn-Oberleitung dargestellt, während Figur 8 eine Überwachungseinrichtungen 10 zur Überwachung insbesondere der thermischen Belastung eines Leiters 2 zeigt. Die Oberleitung 2 dient zur Energieversorgung eines Schienentriebfahrzeugs 31 über einen Stromabnehmer 32.

Die Oberleitung 2 besteht im Wesentlichen aus stromtragfähigen Komponenten wie Einspeiseleitung (nicht dargestellt in Figur 1), Tragseil 22, Fahrdraht 21, und diversen Hilfs-Elementen wie Hängern 23 und passenden Verbindungselementen 24 beispielsweise in Gestalt von Klemmen oder Kauschen. Zur Halterung der Oberleitung 2 sind mehrere Masten 30 vorgesehen. Über den Fahrdraht 21 wird die zum Betrieb des Schienentriebfahrzeugs 31 benötigte Leistung von beispielsweise 12 MW und mehr an den Ort des Stromabnehmers 32 (Pantograph) des Schienentriebfahrzeugs 31 transportiert. Der Fahrdraht 21 steht mit einer (in Figur 1 und 8 nicht gezeigten) quer zum Fahrdraht 21 angeordneten Schleifleiste des Stromabnehmers 32 in Schleifkontakt. Die Schleifleiste wird dabei mit einer gewissen Kraft, der sogenannten Kontaktkraft, gegen den Fahrdraht 21 gedrückt. Dadurch wird ein für die elektrische Energieeinspeisung ausreichender elektrischer Kontakt zwischen Fahrdraht 21 und Stromabnehmer 32 gebildet. Das zumindest bei einer Oberleitung 2, die für eine Geschwindigkeit des Schienentriebfahrzeugs 31 von über 100 km/h ausgelegt ist, vorhandene Tragseil 22 hat eine Tragefunktion und dient aber auch zusätzlich zur Stromzuführung. Bei einer modernen Oberleitung 2, die eine sehr hohe Geschwindigkeit ermöglicht, können zur Stromzuführung neben dem Fahrdraht 21 und dem Tragseil 22 auch weitere elektrische (Teil-)Leiter, beispielsweise in Form einer sogenannten Verstärkungsleitung, vorgesehen sein.

Zur Verdeutlichung des verteilten Stromflusses in der Oberleitung 2 sind in der Darstellung von Figur 1 beispielhaft im Fahrdraht 21, im Tragseil 22 und in einem Hänger 23 fließende Ströme I1, I2 bzw. I3 eingetragen. Diese Ströme I1 I2 und I3 können in Verbindung mit äußeren Einflüssen, wie beispielsweise Temperatur und anderen klimatischen Bedingungen, zu einer thermischen und auch mechanischen Belastung von einzelnen Komponenten der Oberleitung 2 oder der gesamten Oberleitung 2 führen. Um diese thermische und mechanische Belastung möglichst frühzeitig zu erkennen, sind optische Sensoren in Form von Faser-Bragg-Gitter(FBG)-Sensoren 41 bis 45 und 51 bis 53 vorgesehen. Die in Figur 1 dargestellte Verteilung dieser FBG-Sensoren 41 bis 45 und 51 bis 53 ist nur beispielhaft zu verstehen. Andere Sensor-Verteilungen sind ebenso möglich. Die FBG-Sensoren 41 bis 45 sind temperaturempfindlich und die FBG-Sensoren 51 bis 53 sind dehnungsempfindlich.

Die FBG-Sensoren 41 bis 45 sowie 51 bis 53 sind im Beispiel von Figur 1 mit unregelmäßigen Abständen (optisch seriell zueinander) in einen Lichtwellenleiter 40 eingeschrieben. Sie sind damit integrale Bestandteile desselben. Eine Einrichtung mit mehreren, insbesondere optisch parallel zueinander angeordneten Lichtwellenleitern mit integrierten FBG-Sensoren ist ebenfalls möglich. Auch kann für den Lichtwellenleiter 40 wie in Figur 1 dargestellt ein einstückiger Aufbau oder aber ein Aufbau aus mehreren, zumindest optisch miteinander verbundenen Teilabschnitten gewählt werden.

Zur Verdeutlichung der auf den Fahrdraht 21 wirkenden Kraftrichtungen ist in Figur 8 ein Koordinatensystem 80 mit einer x-, y- und z-Achse aufgetragen. Die Kraftkomponente in z-Richtung kann als die Kontaktkraft verstanden werden. Die Kräfte in y-Richtung treten als Quer- und Schnittkräfte auf und sind beispielsweise auf die abschnittsweise Mitführung des Fahrdrahtes 21 in Riefen einer defekten Schleifleiste zurückzuführen. Quer- und Schnittkräfte treten auch aufgrund der Zickzack-Anordnung des Fahrdrahtes 21 in Fahrtrichtung auf, die bei Fahrt des Schienentriebfahrzeugs 31 eine Querbewegung des Fahrdrahtes 21 relativ zum Stromabnehmer 32 und eine damit einhergehende Reibungskraft zur Folge hat. Die Kräfte in x-Richtung werden Längskräfte genannt und werden durch die Reibung zwischen Schleifleiste und Fahrdraht 21 bei Fahrt in Fahrtrichtung hervorgerufen.

Zur Ermittlung der mechanischen Belastung sind optische Sensoren 54 bis 56 in Form von Faser-Bragg-Gitter(FBG)-Sensoren vorgesehen. Die in Figur 8 dargestellte Verteilung dieser FBG-Sensoren 54 bis 56 ist nur beispielhaft zu verstehen. Andere Sensor-Verteilungen sind ebenso möglich. Die einzelnen Messabschnitte längs des Leiters 2 sind jeweils mit einem Sensorenpaar 54 bis 56 versehen, die in Lichtwellenleitersträngen eingeschrieben sind. Jeder Sensor eines Paares 54 bis 56 ist einem Lichtwellenleiterstrang zugeordnet. Der in Figur 8 dargestellte Lichtwellenleiter 40 ist somit als Doppelstrang zu verstehen. Es sind an einem Messort auch mehr als zwei Sensoren, die jeweils einem Lichtwellenleiterstrang zugeordnet sind, denkbar. Die Lichtwellenleiterstränge können dabei Teile eines einzigen Lichtwellenleiters 2 sein oder aber auch jeweils einem Lichtwellenleiter 2 entsprechen. Der bzw. die Lichtwellenleiter 2 können einstückig aufgebaut sein oder aber auch aus mehreren zumindest optisch miteinander verbundenen Teilen.

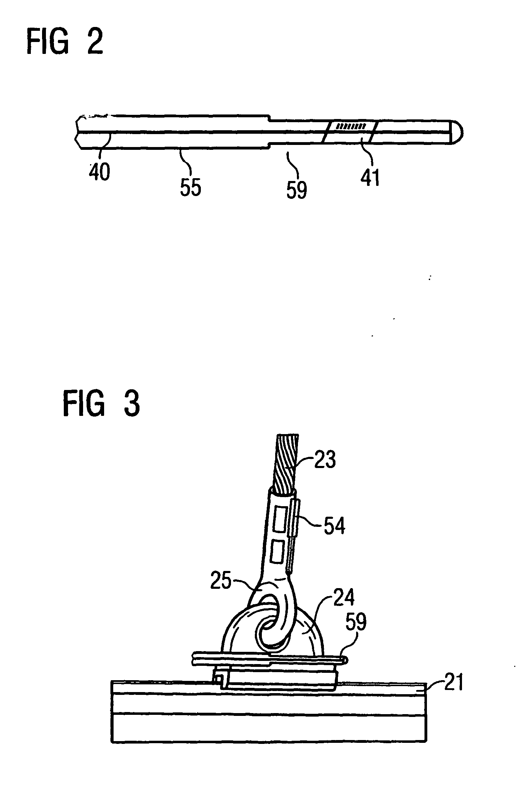

Das durch diese FBG-Sensoren 41 bis 45 und 51 bis 53 in Figur 1 und 54 bis 56 in Figur 2 gebildete Sensor-Netzwerk wird durch ein Lichtsignal LS, das von einer breitbandigen Lichtquelle 61 erzeugt wird, abgefragt. Über einen Koppler 62 und den Lichtwellenleiter(n) 2 wird das Lichtsignal LS in die FBG-Sensoren 54 bis 56 eingespeist.

Jeder der FBG-Sensoren 41 bis 45 und 51 bis 53 in Figur 1 und 54 bis 56 in Figur 2 hat eine spezifische Schwerpunktswellenlänge - die sogenannte Bragg-Wellenlänge -, die sich von derjenigen der anderen FBG-Sensoren 41 bis 45 und 51 bis 53 in Figur 1 und 54 bis 56 in Figur 2 unterscheidet. In jedem Sensor 41 bis 45 und 51 bis 53 in Figur 1 und 54 bis 56 in Figur 2 wird von dem eingespeisten Lichtsignal LS ein Anteil mit der jeweiligen Schwerpunktwellenlänge als Teil-Reflex-Lichtsignal zurückreflektiert. Der übrige Anteil des Lichtsignals LS passiert dagegen den betreffenden Sensor 41 bis 45 und 51 bis 53 in Figur 1 und 54 bis 56 in Figur 2 und trifft auf den nächsten Sensor 41 bis 45 und 51 bis 53 in Figur 1 und 54 bis 56 in Figur 2. Am Koppler 62 steht dann ein von den FBG-Sensoren 41 bis 45 und 51 bis 53 in Figur 1 und 54 bis 56 in Figur 2 zurückreflektiertes Lichtsignal LS' an, das sich aus den Teil-Reflex-Lichtsignalen der einzelnen FBG-Sensoren 41 bis 45 und 51 bis 53 in Figur 1 und 54 bis 56 in Figur 2 zusammensetzt. Unter dem Einfluss der mechanischen Belastung am Ort des jeweiligen Sensors 41 bis 45 und 51 bis 53 in Figur 1 und 54 bis 56 in Figur 2 verändert sich die Schwerpunktwellenlänge des jeweiligen Sensors und damit auch der Wellenlängengehalt (= das Wellenlängenspektrum) des vom betreffenden Sensor 41 bis 45 und 51 bis 53 in Figur 1 und 54 bis 56 in Figur 2 reflektierten Teil-Reflex-Lichtsignals. Diese Veränderung im Lichtwellengehalt dient als Maß für die zu erfassende Größe. Es ist aber auch ein Transmissionsbetrieb denkbar (in Figur 1 und 8 nicht gezeigt). Hier muss im Gegensatz zum Reflexionsbetrieb das gesamte von der Lichtquelle LS ausgesandte Wellenlängenspektrum auf fehlende Wellenlängenbereiche untersucht werden. Denn diese fehlenden Wellenlängenbereiche entsprechen den jeweiligen Schwerpunktswellenlängen der einzelnen Sensoren 41 bis 45 und 51 bis 53 in Figur 1 und 54 bis 56 in Figur 2.

Das am Koppler 62 anstehende reflektierte Lichtsignal LS' wird vom Koppler 62 zu einem optoelektrischen Wandler 63 geleitet. Letzterer beinhaltet insbesondere ein spektral selektives Element zur Selektion der einzelnen Teil-Reflex-Lichtsignale, beispielsweise in Gestalt eines Polychromators und einem gegebenenfalls auch mehrteiligen Lichtempfänger. Zur Analyse des Lichtspektrums sind Gitter- oder Beugungsspektrometer denkbar. Im Anschluss an die optoelektronische Wandlung findet in einem A/D-Wandler 64 eine Analog/Digital-Wandlung statt. Das digitalisierte Ausgangssignal des A/D-Wandlers 64 wird einer digitalen Auswerteeinheit 65 zugeführt, in der Messwerte M1, M2, M3, M4, ... für die in den einzelnen FBG-Sensoren 54 bis 56 erfassten mechanischen Belastungen auf den Leiter 2 ermittelt werden. Im Transmissionsbetrieb hingegen kann auf den Koppler 62 verzichtet werden. Hier wird an einem Ende des Lichtwellenleiter 40 bzw. der Lichtwellenleiter 40 das Lichtsignal LS mittels der Lichtquelle 61 angekoppelt und am anderen Ende des Lichtwellenleiters 40 bzw. der Lichtwellenleiter 40 von einem optoelektrischen Wandler 63 detektiert.

Die Lichtquelle 61, der Koppler 62, der optoelektrische Wandler 63, der A/D-Wandler 64 und die Auswerteeinheit 65 sind in einer Sende/Empfangseinheit 60 zusammengefasst, wobei die Untereinheit aus Lichtquelle 61 und Koppler 62 als Mittel zur Einspeisung des Lichtsignals LS in die FBG-Sensoren 41 bis 45 und 51 bis 53 in Figur 1 und 54 bis 56 in Figur 2 sowie die Untereinheit aus optoelektrischem Wandler 63, A/D-Wandler 64 und Auswerteeinheit 65 als Mittel zur Bestimmung eines Messwertes M1, M2, M3, M4, ... für die von den FBG-Sensoren 41 bis 45 und 51 bis 53 in Figur 1 und 54 bis 56 in Figur 2 jeweils erfasste Einflussgröße aufgefasst werden kann. In einem anderen nicht gezeigten Ausführungsbeispiel können diese Untereinheiten oder Teile davon auch baulich voneinander getrennt, also nicht als gemeinsame Sende-/Empfangseinheit 60, ausgebildet sein. Außerdem ist auch eine rein analoge Auswertung, beispielsweise mittels einer festverdrahteten elektronischen Schaltung möglich. Dann wäre kein A/D-Wandler 64 vorhanden und die Auswerteeinheit 65 analog realisiert.

Die Sende-/Empfangseinheit 60 des jeweils in Figur 1 und Figur 8 gezeigten Beispiels befindet sich auf Erdpotential, wo hingegen die Oberleitung 2 auf einem in der Bahn-Energieversorgung üblichen Potential, insbesondere von 15 bis 25 kV, liegt. Die Überbrückung dieser Potentialdifferenz erfolgt mittels des Lichtwellenleiters 40 bzw. der Lichtwellenleiter 40, über den/die auch das eingespeiste Lichtsignal LS und das reflektierte Lichtsignal LS' übertragen werden. Dadurch ergibt sich ein besonders kompakter Aufbau. Der/Die Lichtwellenleiter 40 besteht/bestehen aus einem dielektrischen Material, wie beispielsweise Glas oder Kunststoff. Damit sind keine gesonderten Maßnahmen zur elektrischen Isolation erforderlich.

Die in der jeweiligen Sende-/Empfangseinheit 60 erzeugten Messwerte M1, M2, M3, M4, ... in Figur 1 und Figur 8 werden mittels einer Funkübertragung zu einer Datenerfassungseinheit 90 übermittelt. Die Datenübertragung kann jedoch grundsätzlich auch leitungsgebunden elektrisch oder optisch erfolgen. Außerdem können die Sende-/Empfangseinheit 60 und die Datenerfassungseinheit 90 auch als gemeinsame Einheit ausgebildet sein.

In der Kontrolleinheit 70 in Figur 1 ist ein Schutzkonzept für die Oberleitung 2 hinterlegt. Je nach Größe der ermittelten Messwerte M1, M2, ... für die tatsächlich vorliegende thermische und mechanische Beanspruchung wird in der Kontrolleinheit 70 entschieden, ob eine Schutzmaßnahme für die Oberleitung 2 zu veranlassen ist. Insbesondere kann der Stromfluss in der Oberleitung 2 reduziert werden, um die Oberleitung 2 im Falle einer zu hohen thermischen oder mechanischen Beanspruchung vor einer Zerstörung zu schützen. Im Extremfall kann die Oberleitung 2 auch stromfrei geschaltet werden. Diese Maßnahmen werden über ein von der Kontrolleinheit 70 generiertes Steuersignal CS eingeleitet. Je nach Grad der festgestellten Überbeanspruchung veranlasst das Steuersignal CS in einer in Figur 1 nicht dargestellten Schalteinheit beispielsweise eine Reduzierung des Stromflusses.

In Figur 8 ist eine weitere Sende-/Empfangseinheit 95 dargestellt, mit der Daten D31 zur Identifizierung der in das "Quality Gate" 11 einfahrenden Schienentriebfahrzeuge empfangen werden. Insbesondere kann ein am Schienentriebfahrzeug 31 angebrachter elektromagnetische Sende-/Empfangseinheit 33 zum Übermitteln dieser Informationen dienen. Die Sende-/Empfangseinheit 33 kann beispielsweise derart ausgeführt sein, dass sie ihre Betriebsenergie aus einem von der Sende-/Empfangseinheit 95 abgestrahlten elektromagnetischen Feld 96 bezieht. Grundsätzlich ist es auch denkbar, die Datenübertragung auf optischem Wege zu vollziehen. Die erhaltenen Schienentriebfahrzeugdaten werden von der Sende-/Empfangseinheit 95 weiter an die Datenerfassungseinheit 90 übermittelt und zusammen mit den entsprechenden, von der Sende-/Empfangseinheit 60 übermittelten Messwerten M3, M4, ... gespeichert. Der für die Oberleitung 2 verantwortliche Infrastrukturbetreiber,hat somit auch zu einem späteren Zeitpunkt die Möglichkeit, auf erfasste und den einzelnen Schienentriebfahrzeugen zügeordnete Messwerte zuzugreifen.

Die von der Sende-/Empfangseinheit 60 an die Datenerfassungseinheit 90 übermittelten Messwerte M3, M4, ... werden darüber hinaus mittels einer Funkübertragung zu einer Kontrolleinheit 70 übermittelt. Die Datenübertragung kann jedoch grundsätzlich auch leitungsgebunden elektrisch oder optisch erfolgen. Außerdem können die Sende-/Empfangseinheiten 60 und 95, die Datenerfassungseinheit 90 und die Kontrolleinheit 70 auch als gemeinsame Einheit ausgebildet sein.

In der Kontrolleinheit 70 ist ein Schutzkonzept für die Oberleitung 2 hinterlegt. Je nach Größe der ermittelten Messwerte M3, M4, ... für die tatsächlich vorliegende mechanische Belastung wird in der Kontrolleinheit 70 entschieden, ob eine Schutzmaßnahme für die Oberleitung 2 zu veranlassen ist. Insbesondere kann die vom Stromabnehmer 32 auf die Oberleitung 2 wirkende Kraft reduziert oder erhöht werden, um die Oberleitung 2 im Falle einer zu hohen mechanischen Belastung vor einer Zerstörung zu schützen. Diese Maßnahmen werden über ein von der Kontrolleinheit 70 generiertes Steuersignal CS eingeleitet, das beispielsweise per Funkübertragung an das Schienentriebfahrzeug 31 gesendet wird. Außerdem können dem Schienentriebfahrzeugführer die seinem Schienentriebfahrzeug 31 zugeordneten Messdaten M3, M4, ... per Funkübertragung übermittelt werden, damit dieser die Möglichkeit hat, bei Notwendigkeit regeln einzugreifen.

In den Figuren 2 bis 7 sind Möglichkeiten zur Anbringung der FBG-Sensoren 41 bis 45 sowie 51 bis 53 an oder in den Komponenten der Oberleitung 2 dargestellt.

Der FBG-Sensor 41 ist gemäß der Darstellung von Figur 2 als in einem Gehäuse 55 eingebetteter Sensor 59 ausgeführt. Der Lichtwellenleiter 40 mit dem integrierten FBG-Sensor 41 befindet sich in einem beispielsweise runden Gehäuse, wodurch der Lichtwellenleiter 40 und der FBG-Sensor 41 vor zu rauen Umgebungsbedingungen geschützt wird und auch eine mechanische Entkopplung des FBG-Sensors 41 von der zu überwachenden Komponente der Oberleitung 2, an oder in der der eingebettete Sensor 59 angebracht werden soll, zu gewährleisten. Bei dem als Temperatursensor ausgeführten FBG-Sensor 41 kommt es nämlich nur auf eine gute thermische Kopplung an, wohingegen eine mechanische Entkopplung vorteilhaft ist. Im Unterschied dazu wäre bei einem FBG-Dehnungssensor 51 bis 53 gerade eine kraftschlüssige Kopplung mit der zu überwachenden Komponente der Oberleitung 2 angestrebt (kraftschlüssige Verbindung).

In Figur 2 ist ein sogenannter "Single Ended"-Sensor gezeigt, bei dem der Lichtpfad nach dem FBG-Sensor 41 beispielsweise in einem optischen Sumpf (= in Figur 2 die nicht näher bezeichnete halbrunde Kappe am rechten Gehäuserand) endet. In einem Sensornetzwerk wie in Figur 1 und Figur 8 dargestellt, kann ein solcher Sensor 59 dann beispielsweise als letzter Sensor im Lichtpfad zum Einsatz kommen. Bei einem Abschluss mit einem Reflektor anstelle mit dem Sumpf kann der Sensor 59 insbesondere in Verbindung mit einem dem Koppler 62 vergleichbaren Element auch an einer beliebigen Stelle im Sensornetzwerk von Figur 1 und Figur 8 verwendet werden. Darüber hinaus ist grundsätzlich auch eine transmissive Ausführungsform möglich. Dann ist am rechten Rand des Gehäuses 55 anstelle des Sumpf- oder Reflektor-Abschlusses ein Auslass für den Lichtwellenleiter 40 vorgesehen.

In Figur 3 ist schematisch dargestellt, wie zwei eingebettete Sensoren 59 gemäß Figur 2 an Verbindungselementen 24 und 25 der Oberleitung 2 angebracht sind. Dabei ist das Element 24 als zusammensteckbare Klemme zur Befestigung des Hängers 23 am Fahrdraht 21 ausgeführt. Das Element 25 ist dagegen eine Kausche mit Kerbverbinder. In ähnlicher Weise lassen sich die FBG-Sensoren 41 bis 45 und 51 bis 53 auch an anderen Verbindungselementen der Oberleitung 2 anbringen.

Beispiele für weitere solcher zur Anbringung eines FBG-Sensors 41 bis 45 und 51 bis 53 geeignete Verbindungselemente sind beispielsweise eine Zahnklemme, eine Stromklemme für das Tragseil 22 oder den Fahrdraht 21, eine schraubbare Klemme zur Befestigung des Hängers 23 am Tragseil 22 oder am Fahrdraht 21, eine Fahrdrahtstoßklemme oder eine Stegklemme.

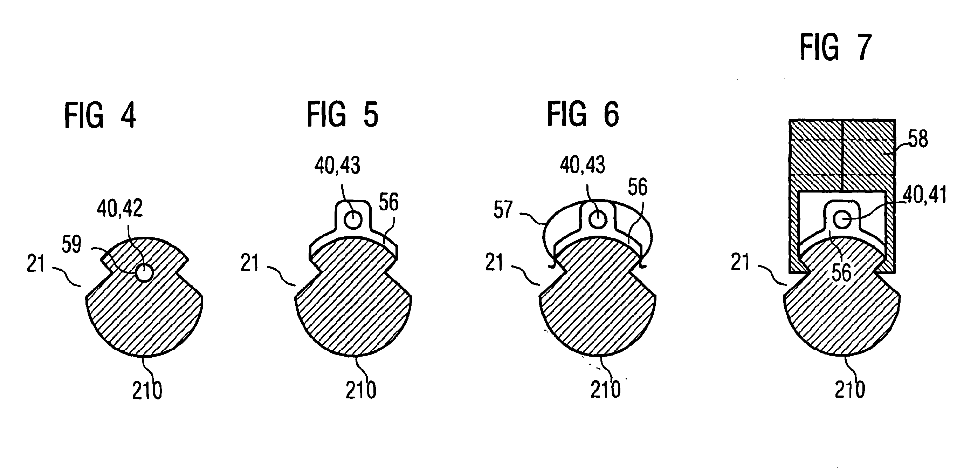

In den Figuren 4 bis 7 sind Möglichkeiten zur Anordnung des Lichtwellenleiters 40 inklusive der beispielhaft ausgewählten FBG-Sensoren 41 bis 43 im bzw. am Fahrdraht 21 dargestellt. Die Anbringung erfolgt dabei jeweils vorzugsweise an oder in einem Bereich des Fahrdrahts 21, der einer Kontaktseite 210 gegenüber liegt. Die Kontaktseite 210 dient zur Schleifkontaktierung des Fahrdrahts 21 mit dem Stromabnehmer 32. Durch die Befestigung in einem der Kontaktseite 210 gegenüber liegenden Bereich wird die mechanische Belastung des Lichtwellenleiters 40 so gering wie möglich gehalten. Gleichzeitig befinden sich die FBG-Sensoren 41 bis 43 immer noch sehr nah an der eigentlich interessierenden Messstelle, nämlich an der thermisch hoch belasteten Kontaktseite 210.

Gemäß Figur 4 ist der Lichtwellenleiter inklusive des Sensors 42 in einem im Fahrdraht 21 vorgesehenen Hohlraum 59 in Form eines in Längsrichtung des Fahrdrahts 21 verlaufenden Hohlkanals angeordnet. Diese Unterbringung ist sehr platzsparend. Die äußeren Abmessungen der Oberleitung 2 werden bei dieser Art der Anbringung des Lichtwellenleiters 40 und des Sensors 42 praktisch nicht verändert.

Bei den in den Figuren 5 bis 7 gezeigten Ausführungsbeispielen ist der Lichtwellenleiter 40 mit den FBG-Sensoren 43 und 41 dagegen nicht im Fahrdraht 21 selbst, sondern in einem zusätzlich vorgesehenen Aufnahmeelement 56, das beispielsweise als Adapter aus Kupfer oder einem Kunststoff ausgebildet sein kann, angeordnet. Das Aufnahmeelement 56 enthält dann einen Hohlkanal, in dem der Lichtwellenleiter 40 inklusive FBG-Sensoren 43 und 41 verlegt ist. Alternativ kann das Aufnahmeelement 56 aber auch formschlüssig um den Lichtwellenleiter 40 und die FBG-Sensoren 43 und 41 angeordnet sein. Eine solcher formschlüssiger Aufbau resultiert insbesondere bei Einsatz eines in der Kunststoffverarbeitung üblichen Herstellungsverfahrens, beispielsweise eines Spritz- und/oder Gussverfahrens.

Das Aufnahmeelement 56 ist im Ausführungsbeispiel nach Figur 5 auf den Fahrdraht 21 aufgeklebt oder aufgelötet und in den Ausführungsbeispielen nach Figur 6 und 7 auf den Fahrdraht 21 aufgeklemmt. Die Klemmverbindung erfolgt gemäß Darstellung von Figur 6 mittels einer zusätzlich vorgesehenen Klemmvorrichtung 57, wohingegen in der Ausführungsform von Figur 7 die Klemmverbindung mittels einer ohnehin vorhandenen Klemmvorrichtung 58 realisiert wird. Der zur Unterbringung des Aufnahmeelements 56 bestimmte Hohlraum innerhalb der Klemmvorrichtung 58 kann dabei - wie im Beispiel von Figur 7 - ohnehin vorhanden sein. Er kann aber auch durch gezieltes Verändern der konstruktiven Elemente der Klemmvorrichtung 58 eingebracht worden sein. Weiterhin kann im Beispiel von Figur 6 anstelle der Klemmvorrichtung 57 auch eine Schraubverbindung vorgesehen sein.

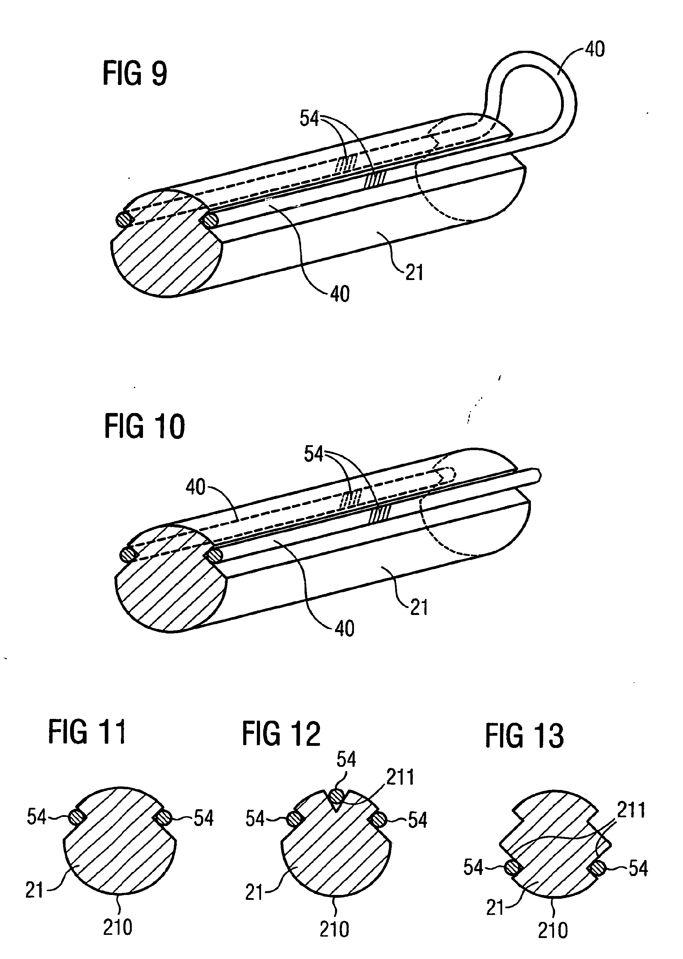

In den Figuren 9 und 10 sind jeweils ein an einem Fahrdrahtabschnitt 21 angebrachtes FBG-Sensorenpaar 54 dargestellt. Figur 9 zeigt ein Ausführungsbeispiel mit einem Lichtwellenleiter 40, während in Figur 10 ein FBG-Sensor jeweils in einem Lichtwellenleiter 40 angeordnet ist. Vorzugsweise sind die FBG-Sensorenpaare 40 parallel zueinander auf gleicher Länge des zu untersuchenden Leiters 2, wie in den beiden Figuren dargestellt, angeordnet.

Figuren 11 bis 13 zeigen anhand von Fahrdrahtquerschnitten, an welchen Stellen FBG-Sensoren 54 bis 56 vorzugsweise angeordnet werden.

In Figur 11 sind zwei FBG-Sensoren 54 in den bereits konstruktionsbedingten Aussparungen des Fahrdrahtes 21 angeordnet. Auch eine Anordnung am Fahrdraht 21 außerhalb der Aussparung ist denkbar. Es muss lediglich ein kraftschlüssiger Kontakt der beiden FBG-Sensoren 54 zum Fahrdraht 21 gewährleistet sein. Hierzu kommen insbesondere Klebe- oder Lötverbindungen in Frage. Da der Stromabnehmer 32 mit der Unterseite des Fahrdrahtes, der Kontaktseite 210, in Kontakt ist, sollte von einer exponierten Anordnung an der Unterseite des Fahrdrahtes 21 möglichst abgesehen werden, um eine Beschädigung der FBG-Sensoren 54 oder der Lichtwellenleiter 40 zu vermeiden.

Es besteht aber auch die Möglichkeit, FBG-Sensoren 54 in Nuten 211 anzuordnen. Damit erhöht sich die Kontaktfläche der FBG-Sensoren 54 mit dem Leiter 2. Dies bringt einen großen Vorteil beim Herstellen einer kraftschlüssigen Verbindung. In Figur 12 ist der Fahrdraht 21 im oberen Teil mit einer Nut 211 versehen dargestellt. In dieser Nut 211 ist ein FBG-Sensor 54 kraftschlüssig eingebettet. Auf der gegenüberliegenden Seite des Fahrdrahtquerschnittes im Stromabnehmerkontaktbereich 210 ist ebenfalls ein in einer Nut 211 eingebetteter FBG-Sensor 54 denkbar. Er muss dabei so tief eingebettet sein, um einen Kontakt mit der Schleifleiste des Stromabnehmers 32 zu vermeiden (diese Ausführungsform ist in den Figuren nicht dargestellt). Figur 13 zeigt eine Ausführungsform, in welcher zwei FBG-Sensoren 54 seitlich in jeweils einer Nut 211 angeordnet sind.

Prinzipiell sind auch andere Positionen der FBG-Sensoren 54 am Leiter 2 über den Rand des Querschnitts verteilt denkbar. Es ist auch denkbar vier oder mehr FBG-Sensoren 54 an einem Leiterabschnitt 2 zu verwenden. Vorzugsweise sind jeweils zwei FBG-Sensoren 54 an den gegenüberliegenden Seiten der Leiteroberfläche eines Leiterabschnitts 2 angeordnet, damit der Unterschied in der Wellenlängenänderung des eingestrahlten Lichtes LS bei Reflexion an den FBG-Sensoren 54, beispielsweise bei einer Biegung des Leiterabschnitts 2, maximal ausfällt.

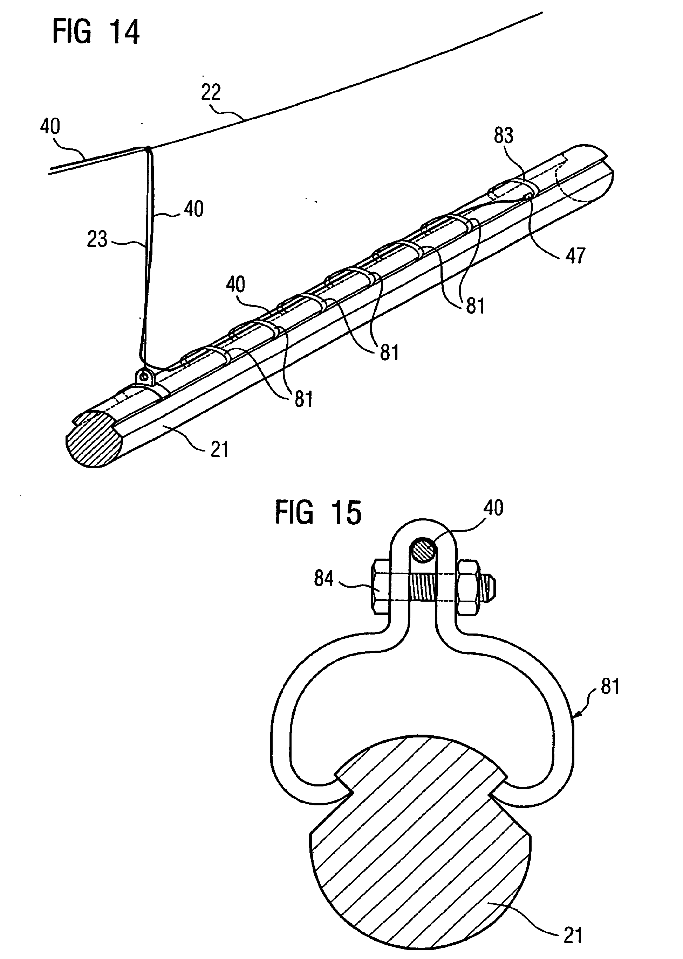

In Figur 14 ist ein Fahrdrahtabschnitt 21 mit einem am Fahrdraht 21 angebrachten Lichtwellenleiter 40 abgebildet. Der Einfachheit halber ist hier der Lichtwellenleiter 40 mit einem "Single-Ended"-Sensor 47 ausgeführt. Es ist zu sehen, dass der Lichtwellenleiter 40 mit Hilfe von Verbindungen 81, insbesondere Klemm- und/oder Schraubverbindungen, am Fahrdraht 21 entlang geführt wird und das Ende des Lichtwellenleiters 40 mit dem optischen Sensor 47 von einer weiteren Klemm- und/oder Schraubverbindung 82 oder 83 am Fahrdraht 21 befestigt wird. Neben den in den Figuren 4 bis 7 und 11 bis 13 dargestellten Ausführungsformen für eine Lichtwellenleiteranbringung an den Fahrdraht 21, sind in den Figuren 15 bis 19 weitere Ausführungsformen, insbesondere als Klemmverbindungen 81 bis 83, abgebildet.

Figur 15 zeigt eine Klemmverbindung 81, die durch eine an einem Vorspannmittel 84, beispielsweise einer Schraube mit Mutter, eingebrachte Vorspannung am Fahrdraht 21 fixiert wird.

Da das Einbringen der Vorspannung gleichzeitig eine Verkleinerung des Krümmungsradius des Bereiches der Klemmverbindung oberhalb des Vorspannmittels 84 hervorruft, wird dadurch der Lichtwellenleiter 40 von der Klemmverbindung 81 selbst festgehalten.

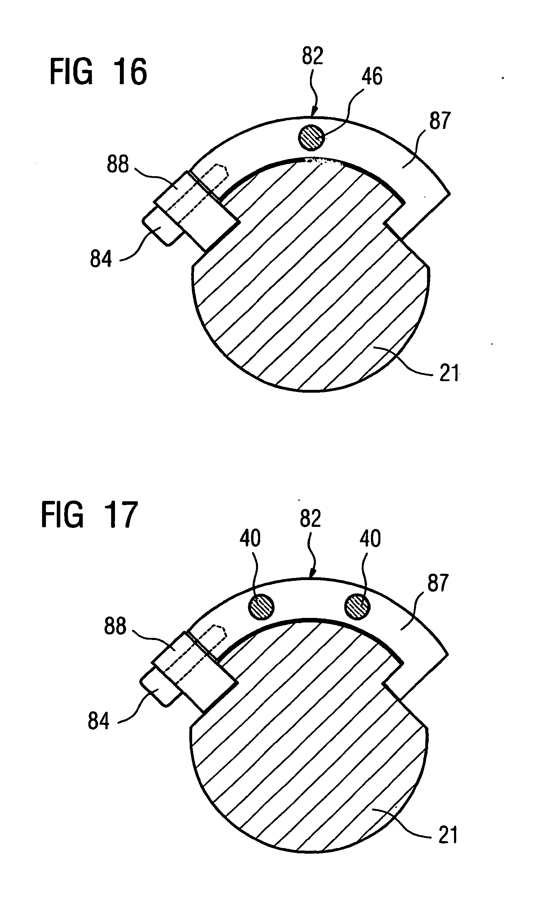

Figur 16 zeigt eine aus einem Flansch 88 und einem bügelartigen Körper 87 bestehende zweiteilige Klemmverbindung 82, die ebenfalls durch eine an einem Vorspannmittel 84, beispielsweise einer Schraube, eingebrachte Vorspannung am Fahrdraht 21 fixiert wird. Die Klemmverbindung 82 ist derart ausgeführt, dass sie formschlüssig auf der Oberseite des Fahrdrahtes 21 angeordnet werden kann. Der Lichtwellenleiter 40 mit dem optischen Sensor 46 hat dabei durch die ebenfalls formschlüssige Fixierung, insbesondere in einer Bohrung der Klemmverbindung 82, kraft- und/oder wärmeschlüssigen Kontakt mit dem Fahrdraht 21.

Figur 17 zeigt weiter eine entsprechende Ausführungsform, mit der zwei Lichtwellenleiter 40 mit optischem Sensor 46 aufgenommen werden können. Denkbar sind auch Ausführungsformen die mehr als zwei Lichtwellenleiter 40 aufnehmen können. Die maximale Zahl der aufnehmbaren Lichtwellenleiter 40 hängt dabei im Wesentlichen von den Abmessungen der entsprechenden Klemmverbindung 82 und den Durchmessern der Lichtwellenleiter 40 ab.

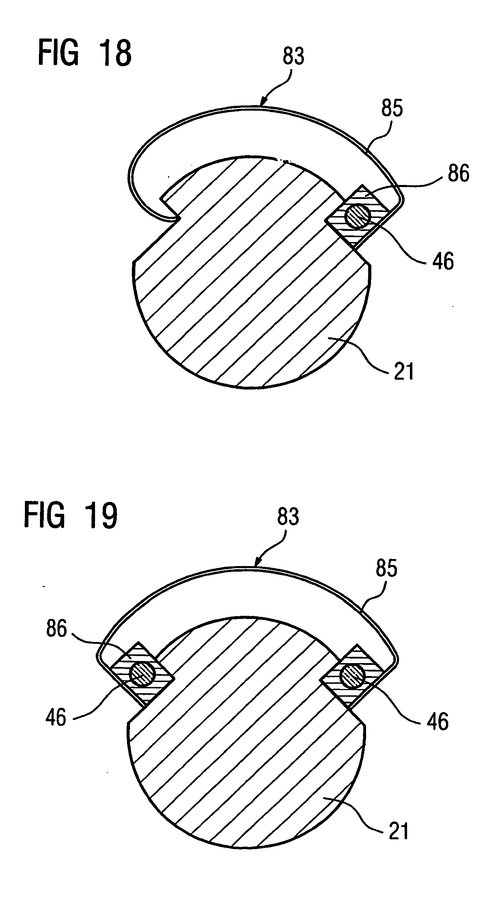

In Figur 18 und 19 ist jeweils ein Ausführungsbeispiel 83 einer Klemmverbindung dargestellt, die ohne zusätzliche Vorspannmittel 84, wie beispielsweise Schrauben, auskommt. Beide abgebildeten Klemmverbindungen 83 bestehen dabei aus einem bzw. zwei Aufnahmeelementen 86, wobei jedes Aufnahmeelement 86 jeweils insbesondere mit einer Bohrung versehen ist und in der formschlüssig und damit kraft- und/oder wärmeschlüssig jeweils ein Lichtwellenleiter 40 angeordnet werden kann. Darüber hinaus haben die beiden Klemmverbindungen 83 jeweils eine elastische Bügel 85, insbesondere eine Blattfeder. Mit Hilfe der Blattfeder 85 kann eine Vorspannung derart aufgebaut werden, dass die jeweilige Klemmverbindung 83 ohne zusätzliches Vorspannmittel 84 am Fahrdraht fixiert werden kann. Das eine Aufnahmeelement 86 aus Figur 18 bzw. die beiden Aufnahmeelemente 86 aus Figur 19 sind dabei so ausgeführt, dass sie formschlüssig Kontakt mit der bereits konstruktionsbedingt vorhandenen Aussparung des Fahrdrahtes 21 haben. Dies gewährt letztendlich einen kraft- und/oder wärmeschlüssigen Kontakt des optischen Sensors 46 bzw. der optischen Sensoren 46 mit dem Fahrdraht 21. Darüber hinaus ist die Montage der Klemmverbindungen 83 denkbar einfach, da sie lediglich auf den Fahrdraht 21 "aufgeklippt" werden müssen. Insbesondere sind die in Figur 16 und 18 gezeigten Ausführungsformen vorzugsweise zur Temperatur- und Dehnungsüberwachung zu verwenden, während die in Figur 17 und 19 dargestellten Ausführungsformen mit ihren jeweils zwei optischen Sensoren 46 vorzugsweise zur Bestimmung der von außen auf den Fahrdraht

Die in den Figuren 1 und 8 gezeigten Überwachungseinrichten lassen sich ohne weiteres auch kombinieren. So kann zusammen mit der Übehrwachung der mechanischen Belastung stets die Übehrwachung der thermische Belastung der zu überwachenden Leitekomponenten durchgeführt werden. Dies unterstreicht besonders die vorteilhafte Flexibilität und Kompatibilität beider in den Figuren 1 uns 8 dargestellten Einrichtungen.

## Patentansprüche

1. Oberleitung zur elektrischen Energieversorgung eines Schienentriebfahrzeugs (31) mit optischer Kraftmesseinrichtung umfassend
- mindestens einen in oder an einer Komponente der Oberleitung (2, 21, 22, 23, 24, 25) kraftschlüssig angeordneten Faser-Bragg-Gitter-Sensor (46, 47, 51, 52, 53, 54, 55, 56),
- Einspeisemittel (61, 32) zur Einspeisung eines Lichtsignals (LS) in den mindestens einen Faser-Bragg-Gitter-Sensor (46, 47, 51, 52, 53, 54, 55, 56), wobei
- eine Verformung der Komponente durch eine von außen von einem Stromabnehmer (32) des Schienentriebfahrzeuges (31) auf die Oberleitung (2, 21, 22, 23) wirkende Kraft bewirkt ist, und
- die zu ermittelnde Verformung der Komponente der Oberleitung (2, 21, 22, 23, 24, 25) mit einer Änderung des Lichtsignals (LS') behaftet ist,
und
- Auswertemittel (62, 63, 64, 65), mit welchen ein Messwert (M1, M2, M3, M4) für die auf die Oberleitung (2, 21, 22, 23, 24, 25) vom Stromabnehmer (32) aus wirkende Kraft aus der verformungsbedingten Änderung des Lichtsignals (LS') zu bestimmen ist.

2. Oberleitung mit optischer Kraftmesseinrichtung nach Anspruch 1, bei der
- mindestens ein zweiter Faser-Bragg-Gitter-Sensor (46, 47, 51, 52, 53, 54, 55, 56) an der Komponente der Oberleitung (2, 21, 22, 23, 24, 25) anzuordnen ist, mit dem mindestens ein zweiter Messwert (M3, M4) in entsprechender Weise zu ermitteln ist,
und
- mittels der mindestens beiden Messwerte (M3, M4) die Richtung der von außen vom Stromabnehmer (32) auf die Oberleitung (2, 21, 22, 23) wirkenden Kraft mit den Auswertemitteln (62, 63, 64, 65) zu bestimmen ist.

3. Oberleitung mit optischer Kraftmesseinrichtung nach Anspruch 1 oder 2, bei der mehrere Faser-Bragg-Gitter-Sensoren (46, 47, 51, 52, 53, 54, 55, 56) zur Verformungserfassung an verschiedenen Stellen längs der Oberleitung (2, 21, 22, 23) vorgesehen sind.

4. Oberleitung mit optischer Kraftmesseinrichtung nach einem der Ansprüche 1 bis 3, bei der die Komponente der Oberleitung (2, 21, 22, 23) Teil eines Kettenwerks (2) ist.

5. Oberleitung mit optischer Kraftmesseinrichtung nach einem der Ansprüche 1 bis 4, bei der der mindestens eine Faser-Bragg-Gitter-Sensor (46, 47, 51, 52, 53, 54, 55, 56) in mindestens einer Nut (211) an der Komponente der Oberleitung (2, 21, 22, 23) angeordnet ist.

6. Oberleitung mit optischer Kraftmesseinrichtung nach einem der Ansprüche 1 bis 5, bei der der mindestens eine Faser-Bragg-Gitter-Sensor (46, 47, 51, 52, 53, 54, 55, 56) mittels einer Klebe-, Löt-, Klemm- oder Schraubverbindung an der Komponente der Oberleitung (2, 21, 22, 23) angebracht ist.

7. Oberleitung mit optischer Kraftmesseinrichtung nach einem der Ansprüche 1 bis 6, bei der die Oberleitung (2, 21, 22, 23) einen zur Kontaktierung des Stromabnehmers (32) des Schienentriebfahrzeugs (31) bestimmten Fahrdraht (21) mit einer Kontaktseite (210) aufweist und der mindestens eine Faser-Bragg-Gitter-Sensor (46, 47, 51, 52, 53, 54, 55, 56) an einer der Kontaktseite (210) im Wesentlichen abgewandten Seite am Fahrdraht (2, 21, 22, 23) angeordnet ist.

8. Oberleitung mit optischer Kraftmesseinrichtung nach einem der Ansprüche 1 bis 7, bei der Mittel zur Identifikation des Schienentriebfahrzeugs (31) vorgesehen sind und diesem die Messwerte (M3, M4) zuzuordnen sind.

9. Oberleitung mit optischer Kraftmesseinrichtung nach einem der Ansprüche 1 bis 8, bei der Steuermittel (70) zur Veranlassung einer Schutzmaßnahme für die Oberleitung (2, 21, 22, 23) in Abhängigkeit der von außen auf die Oberleitung (2, 21, 22, 23) wirkenden Kraft vorgesehen sind.

10. Oberleitung mit optischer Kraftmesseinrichtung nach Anspruch 6, bei der Mittel zur Fixierung der Klemmverbindung (81, 82, 83) an dem Fahrdraht (21) unter Ausbildung einer Vorspannung vorgesehen sind.

11. Oberleitung mit optischer Kraftmesseinrichtung nach Anspruch 10, bei der mit Hilfe der Vorspannung in der Klemmverbindung (81, 82, 83) mindestens ein Faser-Bragg-Gitter-Sensor (46, 47, 51, 52, 53, 54, 55, 56) an der Klemmverbindung (81, 82, 83) fixiert ist.

12. Oberleitung mit optischer Kraftmesseinrichtung nach Anspruch 10 oder 11, bei der mit Hilfe der Vorspannung die Klemmverbindung (81, 82, 83) formschlüssig und/oder kraftschlüssig und/oder wärmeschlüssig an den Fahrdraht (21) angeordnet ist.

13. Oberleitung mit optischer Kraftmesseinrichtung nach einem der Ansprüche 10 bis 12, bei der die Klemmenverbindung (81, 82, 83) an einem oder an jeweils einem Ende ein Aufnahmeelemente (86) umfasst und mit einer klammerartigen Umfassung mit einem elastischen Bügel (85) ausgestaltet ist, wobei mithilfe des elastischen Bügels (85) das eine bzw. die beiden Aufnahmeelemente (86) formschlüssig und/oder kraftschlüssig und/oder wärmeschlüssig unter Ausbildung der Vorspannung jeweils in einer Aussparung des Fahrdraht (21) angeordnet sind.

14. Oberleitung mit optischer Kraftmesseinrichtung nach einem der Ansprüche 10 bis 12, bei der die optische Kraftmesseinrichtung mindestens einen in einem Gehäuse (55) mechanisch entkoppelt eingebetteten, an oder in der oder einer weiteren Komponente der Oberleitung (2, 21, 22, 23, 24, 25) angeordneten weiteren Faser-Bragg-Gitter-Sensor (41, 42, 43, 44, 45 59) umfasst, wobei
- mittels der Einspeisemittel (61, 32) das Lichtsignals (LS) in den mindestens einen weiteren Faser-Bragg-Gitter-Sensor (41, 42, 43, 44, 45, 59) einzuspeisen ist,
- die zu erfassende Temperatur der Komponente der Oberleitung (2, 21, 22, 23, 24, 25) eine Änderung des Lichtsignals (LS') bewirkt
und
- mittels der Auswertemittel (62, 63, 64, 65) ein Messwert (M1, M2, M3, M4) für die Temperatur der Komponente der Oberleitung (2, 21, 22, 23, 24, 25) aus der temperaturbedingten Änderung des Lichtsignals (LS') zu bestimmen ist.

15. Oberleitung mit optischer Kraftmesseinrichtung nach Anspruch 14, bei der Steuermittel (70) zur Veranlassung einer weiteren Schutzmaßnahme für die Oberleitung (2, 21, 22, 23, 24, 25) in Abhängigkeit des Temperaturmesswerts (M1, M2) vorgesehen sind.

16. Oberleitung mit optischer Kraftmesseinrichtung nach Anspruch 14 oder 15, bei der mehrere Faser-Bragg-Gitter-Sensoren (41, 42, 43, 44, 45, 59) zur Temperaturerfassung an verschiedenen Stellen längs der Oberleitung (2, 21, 22, 23, 24, 25) vorgesehen sind.

17. Oberleitung mit optischer Kraftmesseinrichtung nach einem der Ansprüche 14 bis 16, bei der der mindestens eine Faser-Bragg-Gitter-Sensor (42, 59) zur Temperaturerfassung in einem Hohlraum der Komponente der Oberleitung (2, 21, 22, 23, 24, 25) angeordnet ist.

18. Oberleitung mit optischer Kraftmesseinrichtung nach einem der Ansprüche 14 bis 16, bei der der mindestens eine Faser-Bragg-Gitter-Sensor (41, 43, 59) zur Temperaturerfassung in einem an der Komponente der Oberleitung (2, 21, 22, 23, 24, 25) angebrachten Aufnahmeelement (56) angeordnet ist.

19. Oberleitung mit optischer Kraftmesseinrichtung nach einem der Ansprüche 14 bis 18, bei der der mindestens eine Faser-Bragg-Gitter-Sensor (41, 42, 43, 44, 45, 59) zur Temperaturerfassung mittels einer Kleb-, Löt-, Klemm- oder Schraubverbindung (57, 58) an der Komponente der Oberleitung (2, 21, 22, 23, 24, 25) angebracht ist.

20. Oberleitung mit optischer Kraftmesseinrichtung nach einem der Ansprüche 14 bis 19, bei der die Oberleitung (2, 21, 22, 23, 24, 25) einen zur Kontaktierung eines Stromabnehmers (32) eines Schienentriebfahrzeugs (31) bestimmten Fahrdraht (21) mit einer Kontaktseite (210) aufweist und der mindestens eine Faser-Bragg-Gitter-Sensor (41, 42, 43, 59) zur Temperaturerfassung an einer der Kontaktseite (210) im Wesentlichen gegenüberliegenden Seite im oder am Fahrdraht (21) angeordnet ist.

21. Optisches Kraftmessverfahren zur Bestimmung einer von einem Stromabnehmer (32) eines Schienentriebfahrzeugs (31) aus auf eine zur elektrischen Energieversorgung des Schienentriebfahrzeugs (31) bestimmten Oberleitung (2, 21, 22, 23) wirkenden Kraft, bei welchem Verfahren
- mindestens ein Faser-Bragg-Gitter-Sensor (46, 47, 51, 52, 53, 54, 55, 56) kraftschlüssig in oder an einer Komponente der Oberleitung (2, 21, 22, 23, 24, 25) angeordnet wird,
- ein in den mindestens einen Faser-Bragg-Gitter-Sensor (46, 47, 51, 52, 53, 54, 55, 56) eingespeistes Lichtsignal (LS) aufgrund einer Verformung der Komponente der Oberleitung (2, 21, 22, 23, 24, 25) verändert wird, wobei die Verformung der Komponente durch die von außen vom Stromabnehmer (32) auf die Oberleitung (2, 21, 22, 23) wirkende Kraft bewirkt wird,
und
- aus der verformungsbedingten Veränderung des Lichtsignals (LS') ein Messwert (M3, M4) für die auf die Oberleitung (2, 21, 22, 23, 24, 25) vom Stromabnehmer (32) aus wirkende Kraft ermittelt wird.

22. Optisches Kraftmessverfahren nach Anspruch 21, bei dem
- mindestens ein zweiter Faser-Bragg-Gitter-Sensor (54, 55, 56) an der Komponente der Oberleitung (2, 21, 22, 23, 24, 25) angeordnet wird, mit dem mindestens ein zweiter Messwert (M3, M4) in entsprechender Weise ermittelt wird,
und
- mittels der mindesten beiden Messwerte (M3, M4) die Richtung der von außen vom Stromabnehmer (32) auf die Oberleitung (2, 21, 22, 23) wirkenden Kraft bestimmt wird.

23. Optisches Kraftmessverfahren nach Anspruch 21 oder 22, bei dem mehrere Faser-Bragg-Gitter-Sensoren (46, 47, 51, 52, 53, 54, 55, 56) zur Verformungserfassung an verschiedenen Stellen längs der Oberleitung (2, 21, 22, 23) angeordnet werden.

24. Optisches Kraftmessverfahren nach einem der Ansprüche 21 bis 23, bei dem der mindestens eine Faser-Bragg-Gitter-Sensor (46, 47, 51, 52, 53, 54, 55, 56) an einer Komponente eines Kettenwerks (2) angeordnet wird.

25. Optisches Kraftmessverfahren nach einem der Ansprüche 21 bis 24, bei dem Mittel zur Identifikation des Schienentriebfahrzeugs (31) vorgesehen sind und diesem die Messwerte (M3, M4) zugeordnet werden.

26. Optisches Kraftmessverfahren nach einem der Ansprüche 21 bis 25, bei dem mit Steuermitteln (70) eine Schutzmaßnahme für die Oberleitung (2, 21, 22, 23) in Abhängigkeit der von außen auf die Oberleitung (2, 21, 22, 23) wirkenden Kraft veranlasst wird.

27. Optisches Kraftmessverfahren nach einem der Ansprüche 21 bis 26, bei dem
- mindestens ein in einem Gehäuse (55) mechanisch entkoppelt eingebetteter weiterer Faser-Bragg-Gitter-Sensor (41, 42, 43, 44, 45 , 59) an oder in der oder einer weiteren Komponente der Oberleitung (2, 21, 22, 23, 24, 25) angeordnet wird,
- ein in den mindestens einen weiteren Faser-Bragg-Gitter-Sensor (41, 42, 43, 44, 45, 59) eingespeistes Lichtsignal (LS) aufgrund der Temperatur der Komponente der Oberleitung (2, 21, 22, 23, 24, 25) am Ort des mindestens einen weiteren Faser-Bragg-Gitter-Sensors (41, 42, 43, 44, 45, 59) verändert wird
und
- aus der temperaturbedingten Veränderung des Lichtsignals (LS') ein Messwert (M1, M2, M3, M4) für die Temperatur der Komponente der Oberleitung (2, 21, 22, 23, 24, 25) ermittelt wird.

28. Optisches Kraftmessverfahren nach Anspruche 27, bei dem in Abhängigkeit des Temperaturmesswerts (M1, M2) eine weitere Schutzmaßnahme für die Oberleitung (2, 21, 22, 23, 24, 25) veranlasst wird.

29. Optisches Kraftmessverfahren nach Anspruch 27 oder 28, bei dem mehrere Faser-Bragg-Gitter-Sensoren (41, 42, 43, 44, 45, 59) zur Temperaturerfassung an verschiedenen Stellen längs der Oberleitung (2, 21, 22, 23, 24, 25) angeordnet werden.

30. Optisches Kraftmessverfahren nach einem der Ansprüche 27 bis 29, bei dem eine lokale Temperaturverteilung zumindest längs eines Teilabschnitts der Oberleitung (2, 21, 22, 23, 24, 25) ermittelt wird.

31. Optisches Kraftmessverfahren nach einem der Ansprüche 27 bis 30, bei dem die weitere Schutzmaßnahme in Abhängigkeit von Temperaturmesswerten von verschiedenen Stellen der Oberleitung (2, 21, 22, 23, 24, 25) oder in Abhängigkeit von einer zumindest längs eines Teilabschnitts der Oberleitung (2, 21, 22, 23, 24, 25) ermittelten lokalen Temperaturverteilung veranlasst wird.

## Claims

1. Overhead line for supplying electrical power to a rail traction vehicle (31) with optical force-measuring device, comprising
- at least one fibre Bragg grating sensor (46, 47, 51, 52, 53, 54, 55, 56) arranged friction-locked in or on a component of the overhead line (2, 21, 22, 23, 24, 25),
- injection means (61, 32) for injecting a light signal (LS) into the at least one fibre Bragg grating sensor (46, 47, 51, 52, 53, 54, 55, 56), wherein
- a deformation of the component is effected by a force acting on the overhead line (2, 21, 22, 23) from the outside by a current collector (32) of the rail traction vehicle (31), and
- the deformation of the component of the overhead line (2, 21, 22, 23, 24, 25), which is to be determined, is associated with a change in the light signal (LS'),
and
- analysis means (62, 63, 64, 65) by means of which a measurement value (M1, M2, M3, M4) for the force acting on the overhead line (2, 21, 22, 23, 24, 25) from the current collector (32) is to be determined from the deformation-related change in the light signal (LS').

2. Overhead line with optical force-measuring device according to Claim 1, in which
- at least one second fibre Bragg grating sensor (46, 47, 51, 52, 53, 54, 55, 56) is to be arranged on the component of the overhead line (2, 21, 22, 23, 24, 25), by means of which at least one second measurement value (M3, M4) is to be determined in corresponding manner,
and
- by means of the at least two measurement values (M3, M4), the direction of the force acting on the overhead line (2, 21, 22, 23) from the outside by the current collector (32) is to be determined by means of the analysis means (62, 63, 64, 65).

3. Overhead line with optical force measuring device according to Claim 1 or 2, in which a number of fibre Bragg grating sensors (46, 47, 51, 52, 53, 54, 55, 56) are provided for detecting deformation at various locations along the overhead line (2, 21, 22, 23).

4. Overhead line with optical force measuring device according to one of Claims 1 to 3, in which the component of the overhead line (2, 21, 22, 23) is part of a catenary (2).

5. Overhead line with optical force measuring device according to one of Claims 1 to 4, in which the at least one fibre Bragg grating sensor (46, 47, 51, 52, 53, 54, 55, 56) is arranged in at least one groove (211) in the component of the overhead line (2, 21, 22, 23).

6. Overhead line with optical force measuring device according to one of Claims 1 to 5, in which the at least one fibre Bragg grating sensor (46, 47, 51, 52, 53, 54, 55, 56) is attached to the component of the overhead line (2, 21, 22, 23) by means of an adhesive, solder, clamping or screw joint.

7. Overhead line with optical force measuring device according to one of Claims 1 to 6, in which the overhead line (2, 21, 22, 23) has a contact wire (21) with a contact side (210) intended for contacting the current collector (32) of the rail traction vehicle (31) and the at least one fibre Bragg grating sensor (46, 47, 51, 52, 53, 54, 55, 56) is arranged on the contact wire (2, 21, 22, 23) on a side essentially facing away from the contact side (210).

8. Overhead line with optical force measuring device according to one of Claims 1 to 7, in which means for identifying the rail traction vehicle (31) are provided and the measurement values (M3, M4) must be correlated with these.

9. Overhead line with optical force measuring device according to one of Claims 1 to 8, in which control means (70) are provided for initiating a protective measure for the overhead line (2, 21, 22, 23) in dependence on the force acting on the overhead line (2, 21, 22, 23) from the outside.

10. Overhead line with optical force measuring device according to Claim 6, in which means for fixing the clamp connection (81, 82, 83) on the contact wire (21) with formation of a prestress are provided.

11. Overhead line with optical force measuring device according to Claim 10, in which at least one fibre Bragg grating sensor (46, 47, 51, 52, 53, 54, 55, 56) is fixed at the clamping joint (81, 82, 83) with the aid of the prestress in the clamp connection (81, 82, 83).

12. Overhead line with optical force measuring device according to Claim 10 or 11, in which the clamp connection (81, 82, 83) is arranged with positive fit and/or friction-locked and/or thermally locked at the contact wire (21) with the aid of the prestress.

13. Overhead line with optical force measuring device according to one of Claims 10 to 12, in which the clamp connection (81, 82, 83) comprises a receiving element (86) at one or at in each case one end and is equipped with a clamp-like envelopment with an elastic bow (85), wherein the one or the two receiving elements (86) are arranged in each case in a recess in the contact wire (21) with the aid of the elastic bow (85) with positive fit and/or friction-locked and/or thermally locked with formation of the prestress.

14. Overhead line with optical force measuring device according to one of Claims 10 to 12, in which the optical force measuring device comprises at least one further fibre Bragg grating sensor (41, 42, 43, 44, 45, 59) embedded mechanically decoupled in a housing (55) on or in the or a further component of the overhead line (2, 21, 22, 23, 24, 25), wherein
- the light signal (LS) is to be injected into the at least one further fibre Bragg grating sensor (41, 42, 43, 44, 45, 59) by means of the injection means (61, 32),
- the temperature to be detected of the component of the overhead line (2, 21, 22, 23, 24, 25) effects a change in the light signal (LS'),
and
- by means of the analysis means (62, 63, 64, 65), a measurement value (M1, M2, M3, M4) for the temperature of the component of the overhead line (2, 21, 22, 23, 24, 25) is to be determined from the temperature-related change in the light signal (LS').

15. Overhead line with optical force measuring device according to Claim 14, in which control means (70) are provided for initiating a further protective measure for the overhead line (2, 21, 22, 23, 24, 25) in dependence on the measured temperature value (M1, M2).

16. Overhead line with optical force measuring device according to Claim 14 or 15, in which a number of fibre Bragg grating sensors (41, 42, 43, 44, 45, 59) for detecting temperature at various locations along the overhead line (2, 21, 22, 23, 24, 25) are provided.

17. Overhead line with optical force measuring device according to one of Claims 14 to 16, in which the at least one fibre Bragg grating sensor (42, 59) for detecting temperature is arranged in a hollow space in the component of the overhead line (2, 21, 22, 23, 24, 25).

18. Overhead line with optical force measuring device according to one of Claims 14 to 16, in which the at least one fibre Bragg grating sensor (41, 43, 59) for detecting temperature is arranged in a receiving element (56) attached at the component of the overhead line (2, 21, 22, 23, 24, 25).

19. Overhead line with optical force measuring device according to one of Claims 14 to 18, in which the at least one fibre Bragg grating sensor (41, 42, 43, 44, 45, 59) for detecting temperature is attached to the component of the overhead line (2, 21, 22, 23, 24, 25) by means of an adhesive, solder, clamping or screw joint (57, 58).

20. Overhead line with optical force measuring device according to one of Claims 14 to 19, in which the overhead line (2, 21, 22, 23, 24, 25) has a contact wire (21) with a contact side (210) intended for contacting a current collector (32) of a rail traction vehicle (31) and the at least one fibre Bragg grating sensor (41, 42, 43, 59) for detecting temperature is arranged in or on the contact wire (21) on a side essentially opposite the contact side (210).

21. Optical force-measuring method for determining a force acting on an overhead line (2, 21, 22, 23), intended for supplying electrical power to the rail traction vehicle (31), from a current collector (32) of a rail traction vehicle (31), in which method
- at least one fibre Bragg grating sensor (46, 47, 51, 52, 53, 54, 55, 56) is arranged friction-locked in or on a component of the overhead line (2, 21, 22, 23, 24, 25),
- a light signal (LS) injected into the at least one fibre Bragg grating sensor (46, 47, 51, 52, 53, 54, 55, 56) is changed due to a deformation of the component of the overhead line (2, 21, 22, 23, 24, 25), wherein the deformation of the component is effected by the force acting on the overhead line (2, 21, 22, 23) from the outside by the current collector (32),
and
- a measurement value (M3, M4) for the force acting on the overhead line (2, 21, 22, 23, 24, 25) from the current collector (32) is determined from the deformation-related change in the light signal (LS').

22. Optical force measuring method according to Claim 21, in which
- at least one second fibre Bragg grating sensor (54, 55, 56) is arranged on the component of the overhead line (2, 21, 22, 23, 24, 25), by means of which at least one second measurement value (M3, M4) is determined in corresponding manner,
and
- by means of the at least two measurement values (M3, M4), the direction of the force acting on the overhead line (2, 21, 22, 23) from the outside by the current collector (32) is determined.

23. Optical force measuring method according to Claim 21 or 22, in which a number of fibre Bragg grating sensors (46, 47, 51, 52, 53, 54, 55, 56) for detecting deformation are arranged at various locations along the overhead line (2, 21, 22, 23).

24. Optical force measuring method according to one of Claims 21 to 23, in which the at least one fibre Bragg grating sensor (46, 47, 51, 52, 53, 54, 55, 56) is arranged at a component of a catenary (2).

25. Optical force measuring method according to one of Claims 21 to 24, in which means for identifying the rail traction vehicle (31) are provided and the measurement values (M3, M4) are correlated with these.

26. Optical force measuring method according to one of Claims 21 to 25, in which, by means of control means (70), a protective measure for the overhead line (2, 21, 22, 23) is initiated in dependence on the force acting on the overhead line (2, 21, 22, 23) from the outside.

27. Optical force measuring method according to one of Claims 21 to 26, in which
- at least one further fibre Bragg grating sensor (41, 42, 43, 44, 45, 59), embedded mechanically decoupled in a housing (55), is arranged on or in the or a further component of the overhead line (2, 21, 22, 23, 24, 25),
- a light signal (LS) injected into the at least one further fibre Bragg grating sensor (41, 42, 43, 44, 45, 59) is changed due to the temperature of the component of the overhead line (2, 21, 22, 23, 24, 25) at the location of the at least one further fibre Bragg grating sensor (41, 42, 43, 44, 45, 59),
and
- a measurement value (M1, M2, M3, M4) for the temperature of the component of the overhead line (2, 21, 22, 23, 24, 25) is determined from the temperature-related change in the light signal (LS').

28. Optical force measuring method according to Claim 27, in which a further protective measure for the overhead line (2, 21, 22, 23, 24, 25) is initiated in dependence on the measured temperature value (M1, M2).

29. Optical force measuring method according to Claim 27 or 28, in which a number of fibre Bragg grating sensors (41, 42, 43, 44, 45, 59) for detecting temperature are arranged at various locations along the overhead line (2, 21, 22, 23, 24, 25).

30. Optical force measuring method according to one of Claims 27 to 29, in which a local temperature distribution at least along a sub-section of the overhead line (2, 21, 22, 23, 24, 25) is determined.

31. Optical force measuring method according to one of Claims 27 to 30, in which the further protective measure is initiated in dependence on measured temperature values of various locations of the overhead line (2, 21, 22, 23, 24, 25) or in dependence on a local temperature distribution determined at least along a subsection of the overhead line (2, 21, 22, 23, 24, 25).

## Revendications

1. Ligne aérienne pour l'alimentation en énergie électrique d'un véhicule ferroviaire automoteur (31) avec dispositif optique de mesure de force comprenant :
- au moins un capteur à réseau de Bragg à fibres optiques (46, 47, 51, 52, 53, 54, 55, 56) agencé par adhérence dans ou sur un composant de la ligne aérienne (2, 21, 22, 23, 24, 25),
- des moyens d'introduction (61, 32) pour l'introduction d'un signal lumineux (LS) dans le ou les capteurs à réseau de Bragg à fibres optiques (46, 47, 51, 52, 53, 54, 55, 56),
- une déformation du composant étant provoquée par une force agissant de l'extérieur, d'un pantographe (32) du véhicule ferroviaire automoteur (31), sur la ligne aérienne (2, 21, 22, 23), et
- la déformation à déterminer du composant de la ligne aérienne (2, 21, 22, 23, 24, 25) étant liée à une variation du signal lumineux (LS'),
et
- des moyens d'évaluation (62, 63, 64, 65) avec lesquels une valeur mesurée (M1, M2, M3, M4) pour la force agissant sur la ligne aérienne (2, 21, 22, 23, 24, 25) à partir du pantographe (32) est à déterminer à partir de la variation du signal lumineux (LS') qui est due à la déformation.

2. Ligne aérienne avec dispositif optique de mesure de force selon la revendication 1, telle que
- au moins un deuxième réseau de Bragg à fibres optiques (46, 47, 51, 52, 53, 54, 55, 56), avec lequel au moins une deuxième valeur mesurée (M3, M4) est à déterminer de manière appropriée, est à agencer sur le composant de la ligne aérienne (2, 21, 22, 23, 24, 25),
et
- au moyen des au moins deux valeurs mesurées (M3, M4), la direction de la force agissant de l'extérieur, du pantographe (32), sur la ligne aérienne (2, 21, 22, 23) est à déterminer avec les moyens d'évaluation (62, 63, 64, 65).

3. Ligne aérienne avec dispositif optique de mesure de force selon la revendication 1 ou 2, telle que plusieurs capteurs à réseau de Bragg à fibres optiques (46, 47, 51, 52, 53, 54, 55, 56) sont prévus pour la détection de la déformation en différents points le long de la ligne aérienne (2, 21, 22, 23).

4. Ligne aérienne avec dispositif optique de mesure de force selon l'une des revendications 1 à 3, telle que le composant de la ligne aérienne (2, 21, 22, 23) fait partie d'un ouvrage formant chaîne (2).

5. Ligne aérienne avec dispositif optique de mesure de force selon l'une des revendications 1 à 4, telle que le ou les capteurs à réseau de Bragg à fibres optiques (46, 47, 51, 52, 53, 54, 55, 56) sont agencés à chaque fois dans au moins une rainure (211) sur le composant de la ligne aérienne (2, 21, 22, 23).

6. Ligne aérienne avec dispositif optique de mesure de force selon l'une des revendications 1 à 5, telle que le ou les capteurs à réseau de Bragg à fibres optiques (46, 47, 51, 52, 53, 54, 55, 56) sont agencés à chaque fois au moyen d'un assemblage par collage, brasage, soudage ou vissage sur le composant de la ligne aérienne (2, 21, 22, 23).

7. Ligne aérienne avec dispositif optique de mesure de force selon l'une des revendications 1 à 6, telle que la ligne aérienne (2, 21, 22, 23) comporte un fil de contact (21) qui est destiné au contact du pantographe (32) du véhicule ferroviaire automoteur (31) et qui a un côté de contact (210) et telle que le ou les capteurs à réseau de Bragg à fibres optiques (46, 47, 51, 52, 53, 54, 55, 56) sont agencés à chaque fois sur le côté sensiblement opposé au côté de contact (210) sur le fil de contact (2, 21, 22, 23).

8. Ligne aérienne avec dispositif optique de mesure de force selon l'une des revendications 1 à 7, telle que des moyens sont prévus pour l'identification du véhicule ferroviaire automoteur (31) et telle que les valeurs mesurées (M3, M4) sont à associer à celui-ci.

9. Ligne aérienne avec dispositif optique de mesure de force selon l'une des revendications 1 à 8, telle que des moyens de commande (70) sont prévus pour réaliser une mesure de protection pour la ligne aérienne (2, 21, 22, 23) en fonction de la force agissant de l'extérieur sur la ligne aérienne (2, 21, 22, 23).

10. Ligne aérienne avec dispositif optique de mesure de force selon la revendication 6, telle que des moyens sont prévus pour la fixation de l'assemblage par serrage (81, 82, 83) au fil de contact (21) en formant une précontrainte.

11. Ligne aérienne avec dispositif optique de mesure de force selon la revendication 10, telle qu'au moins un capteur à réseau de Bragg à fibres optiques (46, 47, 51, 52, 53, 54, 55, 56) est fixé à l'assemblage par serrage (81, 82, 83) à l'aide de la précontrainte dans l'assemblage par serrage (81, 82, 83).

12. Ligne aérienne avec dispositif optique de mesure de force selon la revendication 10 ou 11, telle que, à l'aide de la précontrainte, l'assemblage par serrage (81, 82, 83) est agencé par concordance de forme et/ou par adhérence et/ou par chaleur sur le fil de contact (21).

13. Ligne aérienne avec dispositif optique de mesure de force selon l'une des revendications 10 à 12, telle que l'assemblage par serrage (81, 82, 83) comprend à une extrémité ou à chacune de ses extrémités un élément de logement (86) et est conçu avec un enveloppement en forme de parenthèse avec un étrier élastique (85), l'élément de logement ou les deux éléments de logement (86) étant agencés à l'aide de l'étrier élastique (85) dans un évidement du fil de contact (21) à chaque fois par concordance de forme et/ou par adhérence et/ou par chaleur.

14. Ligne aérienne avec dispositif optique de mesure de force selon l'une des revendications 10 à 12, telle que le dispositif de mesure optique comprend au moins un autre capteur à réseau de Bragg à fibres optiques (41, 42, 43, 44, 45, 59) encastré mais mécaniquement découplé dans un boîtier (55) et agencé dans le ou un autre composant de la ligne aérienne (2, 21, 22, 23, 24, 25),
- le signal lumineux (LS) étant à introduire dans le ou les autres capteurs à réseau de Bragg à fibres optiques (41, 42, 43, 44, 45, 59) à l'aide des moyens d'introduction (61, 32),
- la température à détecter du composant de la ligne aérienne (2, 21, 22, 23, 24, 25) provoquant une variation du signal lumineux (LS'),
et
- telle que, à l'aide des moyens d'évaluation (62, 63, 64, 65), une valeur mesurée (M1, M2, M3, M4) pour la température du composant de la ligne aérienne (2, 21, 22, 23, 24, 25) est à déterminer à partir de la variation du signal lumineux (LS') qui est due à la température.

15. Ligne aérienne avec dispositif optique de mesure de force selon la revendication 14, telle que des moyens de commande (70) sont prévus pour réaliser une mesure de protection pour la ligne aérienne (2, 21, 22, 23, 24, 25) en fonction de la valeur mesurée de température (M1, M2).

16. Ligne aérienne avec dispositif optique de mesure de force selon la revendication 14 ou 15, telle que plusieurs capteurs à réseau de Bragg à fibres optiques (41, 42, 43, 44, 45, 59) sont prévus pour la détection de la température en différents points le long de la ligne aérienne (2, 21, 22, 23, 24, 25).

17. Ligne aérienne avec dispositif optique de mesure de force selon l'une des revendications 14 à 16, telle que le ou les capteurs à réseau de Bragg à fibres optiques (42, 59) pour la détection de la température sont agencés à chaque fois dans une cavité du composant de la ligne aérienne (2, 21, 22, 23, 24, 25).

18. Ligne aérienne avec dispositif optique de mesure de force selon l'une des revendications 14 à 16, telle que le ou les capteurs à réseau de Bragg à fibres optiques (41, 43, 59) pour la détection de la température sont agencés à chaque fois dans un élément de logement (56) placé sur le composant de la ligne aérienne (2, 21, 22, 23, 24, 25).

19. Ligne aérienne avec dispositif optique de mesure de force selon l'une des revendications 14 à 18, telle que le ou les capteurs à réseau de Bragg à fibres optiques (41, 42, 43, 44, 45, 59) pour la détection de la température sont agencés à chaque fois au moyen d'un assemblage par collage, soudage, serrage ou vissage (57, 58) sur le composant de la ligne aérienne (2, 21, 22, 23, 24, 25).

20. Ligne aérienne avec dispositif optique de mesure de force selon l'une des revendications 14 à 19, telle que la ligne aérienne (2, 21, 22, 23, 24, 25) comporte un fil de contact (21) qui est destiné au contact d'un pantographe (32) d'un véhicule ferroviaire automoteur (31) et qui a un côté de contact (210) et telle que le ou les capteurs à réseau de Bragg à fibres optiques (41, 42, 43, 59) pour la détection de la température sont agencés à chaque fois sur le côté sensiblement opposé au côté de contact (210) dans ou sur le fil de contact (21).

21. Procédé optique de mesure de force pour la détermination d'une force agissant à partir d'un pantographe (32) d'un véhicule ferroviaire automoteur (31) sur une ligne aérienne (2, 21, 22, 23) destinée à l'alimentation en énergie électrique du véhicule ferroviaire automoteur (31),
- dans lequel au moins un capteur à réseau de Bragg à fibres optiques (46, 47, 51, 52, 53, 54, 55, 56) est agencé par adhérence dans ou sur un composant de la ligne aérienne (2, 21, 22, 23, 24, 25),
- dans lequel un signal lumineux (LS) introduit dans le ou les capteurs à réseau de Bragg à fibres optiques (46, 47, 51, 52, 53, 54, 55, 56) varie en raison d'une déformation du composant de la ligne aérienne (2, 21, 22, 23, 24, 25), la déformation du composant étant provoquée par une force agissant de l'extérieur, du pantographe (32), sur la ligne aérienne (2, 21, 22, 23),
et
- dans lequel on détermine, à partir de la variation du signal lumineux (LS') qui est due à la déformation, une valeur mesurée (M3, M4) pour la force agissant à partir du pantographe (32) sur la ligne aérienne (2, 21, 22, 23, 24, 25).

22. Procédé optique de mesure de force selon la revendication 21,
- dans lequel au moins un deuxième capteur à réseau de Bragg à fibres optiques (54, 55, 56), avec lequel au moins une deuxième valeur mesurée (M3, M4) est déterminée de manière appropriée, est agencé sur le composant de la ligne aérienne (2, 21, 22, 23, 24, 25),
et
- dans lequel, au moyen des au moins deux valeurs mesurées (M3, M4), la direction de la force agissant de l'extérieur, du pantographe (32), sur la ligne aérienne (2, 21, 22, 23) est déterminée.

23. Procédé optique de mesure de force selon la revendication 21 ou 22, dans lequel plusieurs capteurs à réseau de Bragg à fibres optiques (46, 47, 51, 52, 53, 54, 55, 56) sont prévus pour la détection de la déformation en différents points le long de la ligne aérienne (2, 21, 22, 23).

24. Procédé optique de mesure de force selon l'une des revendications 21 à 23, dans lequel le capteur à réseau de Bragg à fibres optiques (46, 47, 51, 52, 53, 54, 55, 56) est agencé sur un composant d'un ouvrage formant chaîne (2).

25. Procédé optique de mesure de force selon l'une des revendications 21 à 24, dans lequel des moyens sont prévus pour l'identification du véhicule ferroviaire automoteur (31) et dans lequel les valeurs mesurées (M3, M4) sont associées à celui-ci.

26. Procédé optique de mesure de force selon l'une des revendications 21 à 25, dans lequel on réalise avec des moyens de commande (70) une mesure de protection pour la ligne aérienne (2, 21, 22, 23) en fonction de la force agissant de l'extérieur sur la ligne aérienne (2, 21, 22, 23).

27. Procédé optique de mesure de force selon l'une des revendications 21 à 26,
- dans lequel au moins un autre capteur à réseau de Bragg à fibres optiques (41, 42, 43, 44, 45, 59) encastré mais mécaniquement découplé dans un boîtier (55) est agencé sur ou dans le ou un autre composant de la ligne aérienne (2, 21, 22, 23, 24, 25),
- dans lequel un signal lumineux (LS) introduit dans le ou les autres capteurs à réseau de Bragg à fibres optiques (41, 42, 43, 44, 45, 59) varie en raison de la température du composant de la ligne aérienne (2, 21, 22, 23, 24, 25) à l'emplacement du ou des autres capteurs à réseau de Bragg à fibres optiques (41, 42, 43, 44, 45, 59),
et
- dans lequel on détermine à partir de la variation du signal lumineux (LS') qui est due à la température une valeur mesurée (M1, M2, M3, M4) pour la température du composant de la ligne aérienne (2, 21, 22, 23, 24, 25).

28. Procédé optique de mesure de force selon la revendication 27, dans lequel on prend une autre mesure de protection pour la ligne aérienne (2, 21, 22, 23, 24, 25) en fonction de la valeur mesurée de température (M1, M2).

29. Procédé optique de mesure de force selon la revendication 27 ou 28, dans lequel plusieurs capteurs à réseau de Bragg à fibres optiques (41, 42, 43, 44, 45, 59) sont agencés pour la détection de la température en différents points le long de la ligne aérienne (2, 21, 22, 23, 24, 25).

30. Procédé optique de mesure de force selon l'une des revendications 27 à 29, dans lequel on détermine une répartition locale de la température au moins le long d'un tronçon de la ligne aérienne (2, 21, 22, 23, 24, 25).

31. Procédé optique de mesure de force selon l'une des revendications 27 à 30, dans lequel on prend l'autre mesure de protection en fonction de valeurs mesurées de température en différents points de la ligne aérienne (2, 21, 22, 23, 24, 25) ou en fonction d'une répartition locale de température déterminée le long d'un tronçon de la ligne aérienne (2, 21, 22, 23, 24, 25).
